# EUROPEAN PATENT SPECIFICATION

(11) **EP 4 601 019 B1**
(45) Date of publication and mention of the grant of the patent: **06.05.2026**
(21) Application number: 24171058.1
(22) Date of filing: 18.04.2024
(51) Int. Cl.: H10F 19/80, H10F 77/00, H10F 77/42, H10F 77/70

(54) **PHOTOVOLTAIC MODULE AND PHOTOVOLTAIC SYSTEM**
FOTOVOLTAISCHES MODUL UND FOTOVOLTAISCHES SYSTEM
MODULE PHOTOVOLTAÏQUE ET SYSTÈME PHOTOVOLTAÏQUE

(30) Priority: 07.02.2024 CN 202420288989 U
(43) Date of publication of application: 13.08.2025
(73) Proprietor: Longi Green Energy Technology Co., Ltd., Xi'an, Shaanxi 710100 (CN)
(72) Inventor: CHEN, Xiaoniu, Shaanxi 710100 (CN); DING, Chao, Shaanxi 710100 (CN); ZHANG, Liang, Shaanxi 710100 (CN); FENG, Chunnuan, Shaanxi 710100 (CN); LV, Yuan, Shaanxi 710100 (CN)
(74) Representative: Grünecker Patent- und Rechtsanwälte PartG mbB

(56) References cited:
- WO-A1-2012/133973
- WO-A1-2018/105202
- WO-A1-2019/143218
- US-A1- 2011 180 123
- US-A1- 2012 085 397
- US-A1- 2020 161 487
- US-A1- 2023 402 552

## Description

### TECHNICAL FIELD

The present disclosure relates to the field of photovoltaic technologies, and in particular, to a photovoltaic module and a photovoltaic system.

### BACKGROUND

Solar cells can convert solar energy into electric energy, and have a broad application prospect because they utilize clean energy. However, a single solar cell outputs low voltage, and unencapsulated solar cells are susceptible to an environment. To expand the range of application scenarios, a specific number of solar cells are generally connected in series or in parallel to form a photovoltaic module.

The photovoltaic module generally includes a solar cell, a cover and a back sheet located on two opposite sides of the solar cell, among other components. However, existing photovoltaic modules suffer from problems such as severe glare and non-uniform color distributior Examples of relevant photovoltaic modules disclosed in the prior art are described in patent publications US 2011/180123 A1 and WO 2012/133973 A1.

### SUMMARY

The present disclosure provides a photovoltaic module and a photovoltaic system, and aims to resolve problems such as severe glare and non-uniform color in existing photovoltaic modules.

Reflectance in this application refers to reflectance measured within a wavelength range from 300 nm to 1180 nm of sunlight.

According to a first aspect of the present disclosure, a photovoltaic module is provided, including: a laminate, where
the laminate includes:
a solar cell string array, where the solar cell string array includes a plurality of solar cell strings arranged in an array, where each of the solar cell strings includes a plurality of electrically connected solar cells, and average reflectance of each of the solar cells ranges from 2.4% to 2.9%;
a glass cover, located on a first side of the solar cell string array, where a first surface of the glass cover away from the solar cell string array has a plurality of concave-convex structures, and a flatness of a second surface of the glass cover close to the solar cell string array is less than a flatness of the first surface; and
a back sheet, located on a second side of the solar cell string array, where the first side is opposite to the second side.

In the present disclosure, the first surface of the glass cover has a plurality of concave-convex structures, and the first surface of the glass cover is a surface of the glass cover that mainly receives irradiation. A textured reflection or diffused reflection effect may be formed on a surface of the concave-convex structure, so that specular reflection is greatly reduced, reflection spots are sparse, and the brightness is low, bringing a good anti-glare effect. Meanwhile, because the concave-convex structures receive light reflected from each other, the light transmission is increased, the light reflection is reduced, and a light trapping effect is improved. Therefore, the appearance of the photovoltaic module exhibits a black color almost without color difference and more beautiful. In addition, the average reflectance of each of the solar cells ranges from 2.4% to 2.9%, and the average reflectance of each of the solar cells is low, so that the anti-glare effect is further improved, and the appearance of the solar cell exhibits a black color almost without color difference. Through combination of the glass cover and the solar cell, the anti-glare effect of the photovoltaic module is further improved, and the color is more uniform and beautiful.

Optionally, the plurality of concave-convex structures have peaks distributed in an array or distributed in an irregular manner.

A ratio of a height to a width of the concave-convex structure ranges from 0.6 to 1.8, a direction along the height of the concave-convex structure is parallel to a direction along a thickness of the laminate, and a direction along the width of the concave-convex structure is perpendicular to the direction along the thickness of the laminate.

The height of the concave-convex structure ranges from 1.5 µm to 2.5 µm, and the width of the concave-convex structure ranges from 1.5 µm to 2.5 µm.

Optionally, the glass cover is patterned glass; and
the second surface of the glass cover is a smooth surface.

Optionally, a range of reflectance of each of the solar cells is from 0.23% to 24%.

Optionally, the solar cell includes: a silicon substrate, where a surface of the silicon substrate has a textured surface, the textured surface includes a plurality of quasi-pyramid structures, each of the plurality of quasi-pyramid structures includes a pyramid surface and a pyramid vertex, the pyramid surface of the quasi-pyramid structure includes a first sub-surface away from the pyramid vertex and a second sub-surface, and the second sub-surface is a remaining portion other than the first sub-surface in the pyramid surface of the quasi-pyramid structure; and
on the pyramid surface of the quasi-pyramid structure, a surface morphology of the first sub-surface is different from a surface morphology of the second sub-surface; or
the pyramid surface of the quasi-pyramid structure includes branched textures, and a number of branched textures in the second sub-surface is greater than a number of branched textures in the first sub-surface; or
the quasi-pyramid structure further includes at least two side edges, where the side edge includes a lower section away from the pyramid vertex and a first section, and a bending degree of the lower section is less than a bending degree of the first section.

Optionally, a height fluctuation of the first sub-surface is less than a height fluctuation of the second sub-surface; or
a roughness of the first sub-surface is less than a roughness of the second sub-surface.

Optionally, the solar cell further includes a passivation anti-reflection layer on the silicon substrate; the passivation anti-reflection layer includes a first part on the first sub-surface and a second part on the second sub-surface; in the passivation anti-reflection layer, a thickness of the first part is greater than a thickness of the second part along the same direction toward the pyramid vertex; and/or
a thickness of the passivation anti-reflection layer ranges from 60 nm to 70 nm.

Optionally, the solar cell is a back-contact solar cell, and the solar cell string array further includes: a plurality of busbars respectively located at a first end, at a second end, and in a middle portion, where the first end is opposite to the second end in an extending direction of the solar cell string, and the middle portion is located between the first end and the second end;
a black insulating gasket is adhered to a side of the busbar close to the glass cover, the black insulating gasket totally covers a surface of the busbar close to the glass cover, and the busbar is fixed to an adjacent solar cell through a black tape; or
a black blocking object is arranged at a position corresponding to the busbar on the second surface of the glass cover, a projection of the black blocking object covers a projection of the busbar along a thickness direction of the laminate, and the black blocking object includes at least one of black glaze plating, a black adhesive film, or a black tape.

Optionally, the solar cell is a back-contact solar cell, and the solar cell string array further includes: a conductive interconnection member located between adjacent solar cells;
a black tape is adhered to a side of the conductive interconnection member which is close to the glass cover, and the black tape totally covers a surface of the conductive interconnection member which is close to the glass cover; or
a black blocking object is arranged at a position corresponding to the conductive interconnection member on the second surface of the glass cover, a projection of the black blocking object covers a projection of the conductive interconnection member along a thickness direction of the laminate, and the black blocking object includes at least one of black glaze plating, a black adhesive film, or a black tape.

Optionally, a material of the black tape is selected from polyethylene terephthalate or polyimide; and/or
a glaze of the black glaze plating is selected from at least one of titanium oxide, silicon oxide, aluminum oxide, calcium oxide, zinc oxide, magnesium oxide, or barium oxide.

Optionally, the back sheet is a composite back sheet, and a color of a surface of the composite back sheet close to the solar cell string array is black; or
the back sheet is made of a material including glass, a black blocking object is arranged at a position corresponding to a gap between every two of the solar cell strings and a position corresponding to a gap between every two of the solar cells on a surface of the back sheet close to the solar cell string array, and the black blocking object includes at least one of black glaze plating, a black adhesive film, or a black tape.

Optionally, the photovoltaic module further includes: a plurality of black frames located around the laminate, where a first wave pattern is arranged on a surface A of the black frame; and/or
an arc-shaped chamfer is arranged at each corner of the photovoltaic module; and/or
the photovoltaic module further includes a junction box located on a side of the back sheet away from the solar cell string array and a black cable tie configured to tie the junction box and other lines surrounding the junction box.

Optionally, a black sealant is arranged between the laminate and the black frame; and/or
the black cable tie is a black detachable cable tie; and/or
a second wave pattern matching the first wave pattern is arranged on a press block cooperating with the black frame, or at least one of four frames located around the laminate is an anti-dust frame without a surface A; and/or
a laser nameplate is arranged on a surface B and/or a surface C of the black frame; and/or
each of the solar cell strings includes 9 solar cells connected in series, and the solar cell string array is a 6×2 solar cell string array; and/or
a width of the photovoltaic module ranges from 1127 mm to 1138 mm, and a length of the photovoltaic module ranges from 1716 mm to 2400 mm.

Optionally, the back sheet is made of the material including glass, a through-hole is provided on the back sheet, the black blocking object is arranged on the surface of the back sheet and around the through-hole, a distance between the black blocking object arranged around the through-hole and the through-hole ranges from 0 mm to 2.3 mm, and a shape of a portion of the black blocking object close to the through-hole is consistent with a shape of the through-hole.

According to a second aspect of the present disclosure, a photovoltaic system is provided, including a plurality of photovoltaic modules according to any one of the foregoing descriptions arranged in an array.

The photovoltaic module and the photovoltaic system have the same or similar beneficial effects. To avoid repetition, details are not described herein again.

### BRIEF DESCRIPTION OF THE DRAWINGS

To describe technical solutions of embodiments of the present disclosure more clearly, the following briefly describes accompanying drawings that are required for describing the embodiments of the present disclosure.
FIG. 1 is a schematic diagram of light reflection of an existing glass cover;
FIG. 2 is a schematic diagram of an optical path of light of a glass cover according to an embodiment of the present disclosure;
FIG. 3 is a partial schematic structural diagram of a solar cell or cell according to an embodiment of the present disclosure;
FIG. 4 is a scanning electron micrograph of a first silicon substrate according to an embodiment of the present disclosure;
FIG. 5 is a scanning electron micrograph of a second silicon substrate according to an embodiment of the present disclosure;
FIG. 6 is a schematic diagram of a back side of a laminate according to an embodiment of the present disclosure;
FIG. 7 is a partial schematic enlarged view of a back side of a laminate according to an embodiment of the present disclosure;
FIG. 8 is a schematic diagram of a second surface of a glass cover according to an embodiment of the present disclosure;
FIG. 9 is a schematic diagram of a frame according to an embodiment of the present disclosure;
FIG. 10 is a schematic diagram of another frame according to an embodiment of the present disclosure;
FIG. 11 is a schematic diagram of a back side of a photovoltaic module according to an embodiment of the present disclosure;
FIG. 12 is a schematic side view of a photovoltaic module according to an embodiment of the present disclosure;
FIG. 13 is a partial schematic diagram of a surface of a back sheet close to a solar cell string array according to an embodiment of the present disclosure; and
FIG. 14 is a comparison diagram of reflectance of a solar cell in an embodiment of the present disclosure and a solar cell in the related art.

### Descriptions of reference numerals:

1-glass cover, 11-first surface, 12-concave-convex structure, 13-second surface, 121-peak, 2-silicon substrate, 21-pyramid vertex, 22-branched texture, 23-quasi-annular texture, 24-bottom contour line, 25-various quasi-pyramid structures that are integrated, 3-passivation anti-reflection layer, 4-solar cell, 41-short frame, 411-surface A of the short frame, 42-long frame, 421-surface A of the long frame, 5-junction box, 6-black cable tie, 422-laser nameplate, 7-back sheet, 71-through-hole, 8-black blocking object, 9-black insulating gasket, 10-conductive interconnection member, 14-black tape, and 15-busbar.

### DETAILED DESCRIPTION

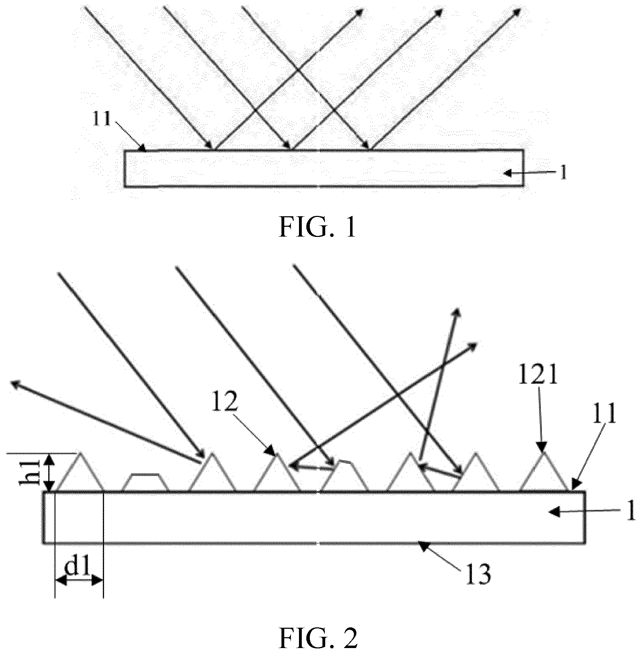

Glare mentioned in this application refers to a phenomenon that strong specular reflection is formed on a surface of an object under irradiation of a strong light source, causing interference to a human visual system. Referring to FIG. 1, in an existing photovoltaic module, a main cause of severe glare lies in that: a flatness of a first surface 11 of a glass cover 1 away from a solar cell string array is low, and the first surface is smooth. As a result, the first surface has strong specular reflection under irradiation of light, reflection spots are centralized, and the brightness is high. For the foregoing technical problems, in the present disclosure, referring to FIG. 2, the first surface 11 of the glass cover 1 has a plurality of concave-convex structures 12. FIG. 2 only schematically shows the concave-convex structures. In practice, the concave-convex structures 12 on the glass cover 1 may be of irregular structures, and the concave-convex structures 12 may be of the same structure or different structures. The first surface 11 of the glass cover 1 is a surface of the glass cover 1 that mainly receives irradiation. A textured reflection or diffused reflection effect may be formed on a surface of the concave-convex structure 12, so that specular reflection is greatly reduced, reflection spots are sparse, and the brightness is low, bringing a good anti-glare effect. Meanwhile, because the concave-convex structures 12 receive light reflected from each other, the light transmission is increased, the light reflection is reduced, and a light trapping effect is improved. Therefore, the appearance of the photovoltaic module exhibits a black color almost without color difference and more beautiful. In addition, average reflectance of a solar cell ranges from 2.4% to 2.9%, and the average reflectance of each of the solar cells is appropriate, so that the anti-glare effect is further improved, and the appearance of the solar cell exhibits a black color almost without color difference. Through combination of the glass cover and the solar cell, the anti-glare effect of the photovoltaic module is further improved, and the color is more uniform and beautiful. Long arrows in FIG. 1 and FIG. 2 are all examples of light.

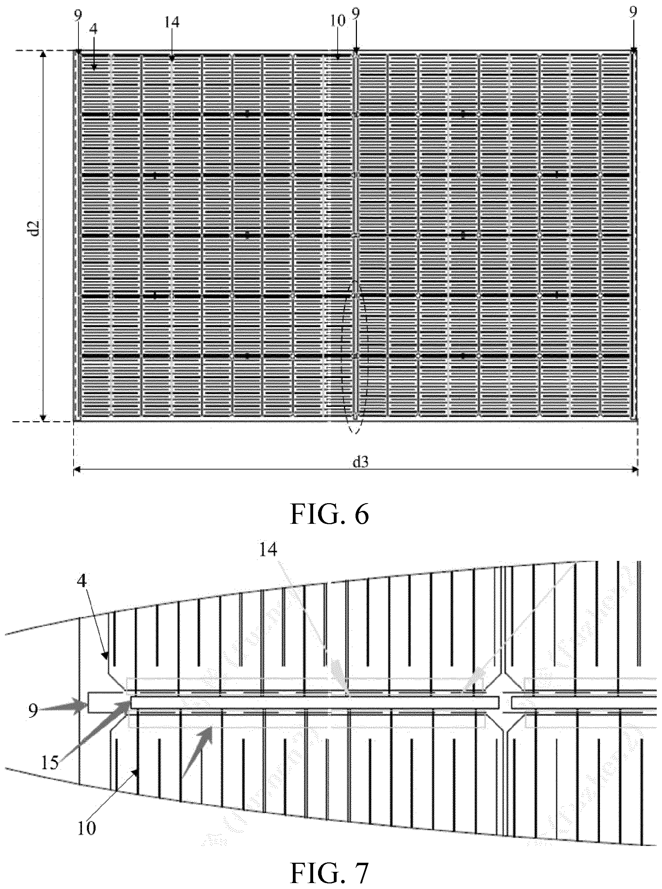

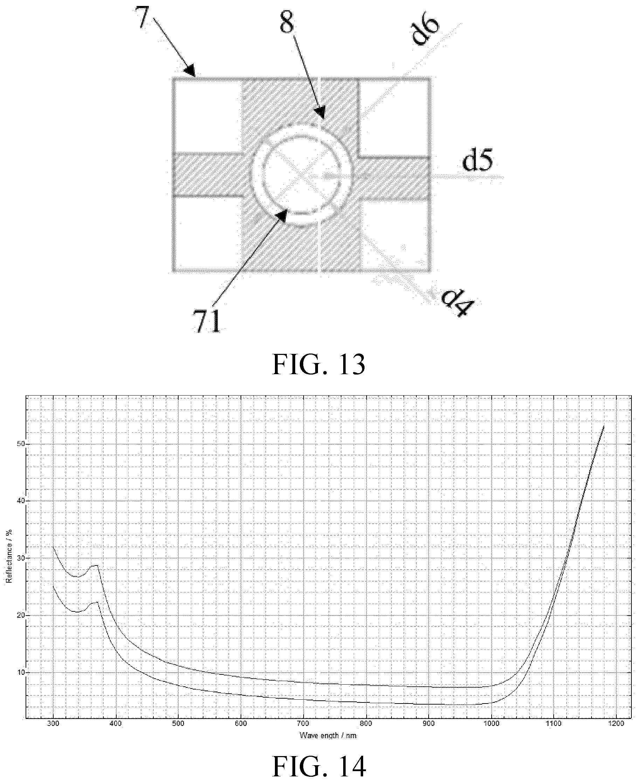

The present disclosure provides a photovoltaic module, including a laminate. The laminate includes a solar cell string array. The solar cell string array includes a plurality of solar cell strings arranged in an array. A number and an arrangement manner of the solar cell strings in the solar cell string array are not specifically limited. Referring to FIG. 6, each of the solar cell strings includes: a plurality of electrically connected solar cells 4. A number and an arrangement manner of the solar cells in the solar cell string are not specifically limited. Referring to FIG. 14, average reflectance of each of the solar cells ranges from 2.4% to 2.9%, and the average reflectance of each of the solar cells may be measured by using a reflectance tester. The average reflectance of each of the solar cells is average reflectance of a surface of each of the solar cells close to a glass cover, and the average reflectance is a weighted average value, which is not specifically limited herein.

For example, the average reflectance of each of the solar cells may be 2.4%, 2.42%, 2.45%, 2.49%, 2.5%, 2.53%, 2.55%, 2.58%, 2.6%, 2.62%, 2.65%, 2.69%, 2.7%, 2.73%, 2.8%, 2.82%, or 2.9%.

The laminate may further include a glass cover 1 located on a first side of the solar cell string array. Referring to FIG. 2, a first surface 11 of the glass cover 1 away from the solar cell string array has a plurality of concave-convex structures 12, and a flatness of a second surface 13 of the glass cover 1 close to the solar cell string array is less than a flatness of the first surface 11. The first surface 11 is opposite to the second surface 13. In the first surface or the second surface, data difference between unevenness and absolute evenness is the flatness, and a smaller value of the flatness indicates a flatter surface. The first surface 11 of the glass cover 1 is a surface of the glass cover 1 that mainly receives irradiation. A textured reflection or diffused reflection effect may be formed on a surface of the concave-convex structure 12, so that specular reflection is greatly reduced, reflection spots are sparse, and the brightness is low, binging a good anti-glare effect. Meanwhile, because the concave-convex structures 12 receive light reflected from each other, the light transmission is increased, the light reflection is reduced, and a light trapping effect is improved. Therefore, the appearance of the photovoltaic module exhibits a black color almost without color difference and more beautiful. In addition, the average reflectance of each of the solar cells ranges from 2.4% to 2.9%, and the average reflectance of each of the solar cells is low, so that the anti-glare effect is further improved, and the appearance of the solar cell exhibits a black color almost without color difference. Through combination of the glass cover and the solar cell, the anti-glare effect of the photovoltaic module is further improved, and the color is more uniform and beautiful.

It should be noted that, a difference value between the flatness of the first surface and the flatness of the second surface is not specifically limited herein. The flatness of the first surface and the flatness of the second surface may be measured by an instrument such as a flatness tester, and a specific measurement instrument or measurement method is not specifically limited.

The laminate may further include a back sheet located on a second side of the solar cell string array. The first side is opposite to the second side, and the first side is a side of the solar cell string array that mainly receives irradiation when the laminate operates normally.

Optionally, the plurality of concave-convex structures 12 have peaks 121 distributed in an array, or referring to FIG. 2, the plurality of concave-convex structures 12 have peaks distributed in an irregular manner. The peak 121 is a highest point in the concave-convex structure 12. In a case that a highest portion of the concave-convex structure 12 is a plane formed by a plurality of points having an equal height, the peak 121 herein may be a geometric center of the plane. That is, the plurality of concave-convex structures 12 are regularly arranged or in an irregular manner distributed, and the concave-convex structures 12 and the peaks 121 can mutually utilize reflected light, that is, more secondary reflected light is utilized, so that transmitted light is further increased, reflection is reduced, and the light trapping effect and the anti-glare effect are improved. Therefore, the appearance of the photovoltaic module exhibits a black color almost without color difference and more beautiful.

A ratio of a height to a width of the concave-convex structure 12 ranges from 0.6 to 1.8, a direction along the height h1 of the concave-convex structure 12 is parallel to a direction along a thickness of the laminate, and a direction along the width d1 of the concave-convex structure 12 is perpendicular to the direction along the thickness of the laminate. The ratio of the height to the width of the concave-convex structure 12 is appropriate, so that the effect of textured reflection or diffused reflection formed on the surface of the concave-convex structure 12 is improved, specular reflection is further reduced, and the anti-glare effect and the light trapping effect are improved. Therefore, the appearance of the photovoltaic module exhibits a black color almost without color difference and more beautiful. In addition, the ratio of the height to the width of the concave-convex structure 12 is appropriate, so that the first surface 11 of the glass cover 1 is not prone to dust accumulation.

For example, the ratio of the height to the width of the concave-convex structure 12 ranges from 0.8 to 1.5. In another example, the ratio of the height to the width of the concave-convex structure 12 may be 0.6, 0.63, 0.7, 0.76, 0.83, 0.91, 0.97, 1.0, 1.03, 1.07, 1.1, 1.15, 1.2, 1.3, 1.34, 1.4, 1.5, 1.53, 1.6, 1.67, 1.77, or 1.8.

The height h1 of the concave-convex structure 12 ranges from 1.5 µm to 2.5 µm, and the width d1 of the concave-convex structure 12 ranges from 1.5 µm to 2.5 µm. The height and the width of the concave-convex structure 12 are suitable, so that the effect of textured reflection or diffused reflection formed on the surface of the concave-convex structure 12 is improved, specular reflection is further reduced, and the anti-glare effect and the light trapping effect are improved. Therefore, the appearance of the photovoltaic module exhibits a black color almost without color difference and more beautiful. In addition, the height and the width of the concave-convex structure 12 are suitable, so that the first surface 11 of the glass cover 1 is not prone to dust accumulation.

For example, the height h1 of the concave-convex structure 12 may be 1.5 µm, 1.53 µm, 1.67 µm, 1.69 µm, 1.73 µm, 1.77 µm, 1.81 µm, 1.93 µm, 1.99 µm, 2 µm, 2.03 µm, 2.07 µm, 2.1 µm, 2.15 µm, 2.2 µm, 2.31 µm, 2.34 µm, 2.4 µm, or 2.5 µm.

For example, the width d1 of the concave-convex structure 12 may be 1.5 µm, 1.6 µm, 1.67 µm, 1.69 µm, 1.73 µm, 1.77 µm, 1.8 µm, 1.93 µm, 1.99 µm, 2 µm, 2.03 µm, 2.07 µm, 2.1 µm, 2.15 µm, 2.2 µm, 2.31 µm, 2.34 µm, 2.4 µm, or 2.5 µm.

Optionally, the glass cover 1 is patterned glass, where one surface of the patterned glass may be a smooth surface, and the other opposite surface may have the concave-convex structures. A surface of the patterned glass embossed with a pattern is the first surface, and the first surface is uneven. When light penetrates the first surface, diffused reflection occurs, so that the patterned glass has a good light trapping effect and a good anti-glare effect and is easy to obtain. The second surface 13 of the glass cover 1 is a smooth surface, so that the glass cover 1 matches a shape of commonly used patterned glass and is easy to obtain.

Optionally, a reflectance range of the solar cell is from 0.23% to 24%. The reflectance range is a range of reflectance of one surface of the solar cell that faces the glass cover 1. The reflectance of each of the solar cells is low, and the light trapping effect is better, so that the appearance of the photovoltaic module exhibits a black color almost without color difference and more beautiful. Referring to FIG. 14, a horizontal axis in the figure represents a wavelength of light irradiated on the solar cell, where a unit of the wavelength is nm, and a vertical axis represents reflectance. In FIG. 14, a blue curve is used to represent reflectance corresponding to the solar cell in the present disclosure, and a red curve is used to represent reflectance corresponding to the solar cell in the related art. It can be learned that, in most wavelength ranges that can be utilized for the solar cell in the present disclosure, reflectance of a front surface of the solar cell in the embodiment is lower.

For example, the reflectance of each of the solar cells may be 0.23%, 0.24%, 0.25%, 0.27%, 0.29%, 0.28%, 0.3%, 0.32%, 0.33%, 0.34%, 0.37%, 0.41%, 0.45%, 0.46%, 0.5%, 0.54%, 0.58%, 0.63%, 0.67%, 1.03%, 1.58%, 3.26%, 4.29%, 5.84%, 12.12%, 14.26%, 19.25%, 23.81%, or 24%.

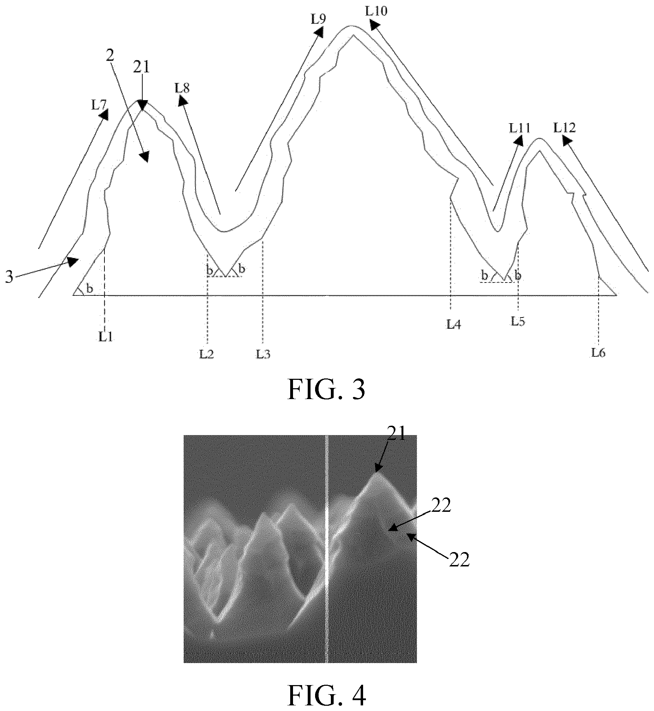

Optionally, referring to FIG. 3, the solar cell includes: a silicon substrate 2, where a surface of the silicon substrate 2 has a textured surface, and the textured surface includes a plurality of quasi-pyramid structures. The silicon substrate 2 may be doped or may be intrinsic, which is not specifically limited herein. The silicon substrate may be a single crystal silicon substrate or the like, which is also not specifically limited herein. Each of the plurality of quasi-pyramid structures includes a pyramid surface and a pyramid vertex 21. The pyramid vertex 21 is a highest point in the quasi-pyramid structure. In a case that a highest portion of the quasi-pyramid structure is a plane formed by a plurality of points having an equal height, the pyramid vertex herein may be a geometric center of the plane. In the quasi-pyramid structure, the pyramid surface of the quasi-pyramid structure is a set of all side surfaces of the quasi-pyramid structure, namely, all surfaces other than a bottom surface and the pyramid vertex in the quasi-pyramid structure. The pyramid surface of the quasi-pyramid structure connects the pyramid vertex and a bottom contour line, and the bottom contour line is a bottommost contour line of the quasi-pyramid structure. The pyramid surface of the quasi-pyramid structure includes a first sub-surface away from the pyramid vertex and a second sub-surface, and the second sub-surface is a remaining portion other than the first sub-surface in the pyramid surface of the quasi-pyramid structure. That is, the first sub-surface is a portion farthest from the pyramid vertex 21 in the pyramid surface, namely, a portion close to the silicon substrate in the pyramid surface, and the second sub-surface is a remaining portion other than the first sub-surface in the pyramid surface. In FIG. 3, dashed lines L1 to L6 do not actually exist in the solar cell, but are marks used to distinguish the first sub-surface and the second sub-surface. For example, in FIG. 3, for a leftmost quasi-pyramid structure, in the pyramid surface, a part located between a right side of the dashed line L1 and a left side of the pyramid vertex of the leftmost quasi-pyramid structure and a part located between a left side of the dashed line L2 and a right side of the pyramid vertex of the leftmost quasi-pyramid structure are the second sub-surface, and a part located on a left side of L1 and a part located on a right side of L2 are the first sub-surface. For a middle quasi-pyramid structure, in the pyramid surface, a part located between a right side of the dashed line L3 and a left side of the pyramid vertex of the middle quasi-pyramid structure and a part located between a left side of the dashed line L4 and a right side of the pyramid vertex of the middle quasi-pyramid structure are the second sub-surface, and a part located on a left side of L3 and a part located on a right side of L4 are the first sub-surface. For a rightmost quasi-pyramid structure, in the pyramid surface, a part located between a right side of the dashed line L5 and a left side of the pyramid vertex of the rightmost quasi-pyramid structure and a part located between a left side of the dashed line L6 and a right side of the pyramid vertex of the right quasi-pyramid structure are the second sub-surface, and a part located on a left side of L5 and a part located on a right side of L6 are the first sub-surface.

A surface morphology of each sub-surface may include a height fluctuation of the sub-surface or a roughness of the sub-surface. The height fluctuation mainly refers to a degree of fluctuation caused by structures having large height differences on a surface, and the roughness refers to a degree of unevenness caused by micro-protrusions/micro-depressions on a surface. Referring to FIG. 3, on the pyramid surface of the quasi-pyramid structure, a surface morphology of the first sub-surface is different from a surface morphology of the second sub-surface. That is, the height fluctuation or the roughness of the first sub-surface is different from the height fluctuation or the roughness of the second sub-surface. In one case, a number of protrusions and/or depressions of the second sub-surface may be greater than a number of protrusions and/or depressions of the first sub-surface. In another case, a protrusion and/or depression degree of the second sub-surface may be greater than a protrusion and/or depression degree of the first sub-surface. In another case, arrangement of the protrusions and/or depressions of the second sub-surface may be more disordered than arrangement of the protrusions and/or depressions of the first sub-surface. In another case, a height of the protrusions and/or a depth of the depressions of the second sub-surface may be greater than a height of the depressions and/or a depth of the depressions of the first sub-surface. Further, a more irregular shape of the pyramid surface of the quasi-pyramid structure indicates a larger specific surface area of the textured surface, lower reflectance, and a better light trapping effect. Therefore, a short-circuit current may be improved, to finally improve the photoelectric conversion efficiency of the solar cell. In addition, the appearance of the solar cell is in a uniform black color and more beautiful, so that the appearance of the photovoltaic module exhibits a black color almost without color difference and more beautiful.

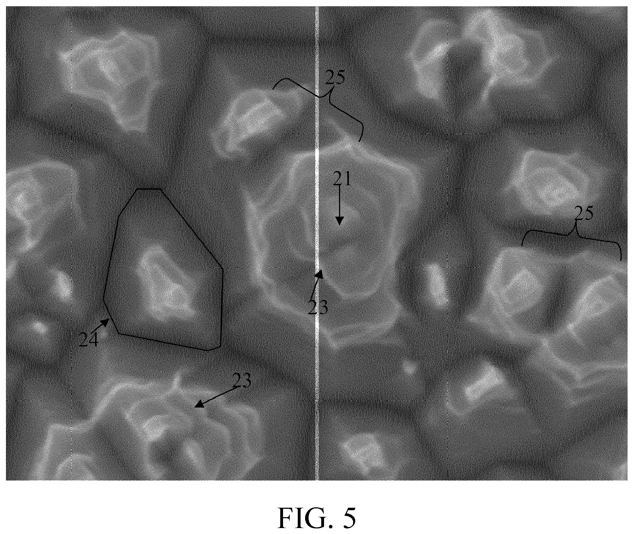

FIG. 4 is a scanning electron micrograph obtained by performing scanning mainly from a front surface of the textured surface. FIG. 5 is a scanning electron micrograph obtained by performing scanning mainly in a direction from the pyramid vertex of the quasi-pyramid structure of the textured surface to the bottom contour line.

Optionally, referring to FIG. 4, the pyramid surface of the quasi-pyramid structure includes branched textures 22, where a shape of the branched texture 22 is similar to a shape of a tree branch, and the branched texture 22 is a texture having a branch on a trunk. In the pyramid surface of the quasi-pyramid structure, a number of branched textures 22 in the second sub-surface is greater than a number of branched textures 22 in the first sub-surface in the pyramid surface of the quasi-pyramid structure. There is a correspondence between the branched textures 22 and the protrusions or depressions on the pyramid surface of the quasi-pyramid structure. The branched textures 22 are generally located at junctions of the protrusions and the depressions on the pyramid surface of the quasi-pyramid structure. That is, a greater number of branched textures 22 indicates a greater number of protrusions and depressions on the pyramid surface of the quasi-pyramid structure, and therefore, a greater number of textures indicates a larger specific surface area of the textured surface. More irregular position distribution of the branched textures indicates a larger specific surface area of the textured surface, lower reflectance, and a better light trapping effect. Therefore, the short-circuit current may be improved, to finally improve the photoelectric conversion efficiency of the solar cell. In addition, the appearance of the solar cell is in a uniform black color and more beautiful, so that the appearance of the photovoltaic module exhibits a black color almost without color difference and more beautiful. For example, in FIG. 4, in the pyramid surface of the rightmost quasi-pyramid structure, the first sub-surface basically has no branched texture, and the second sub-surface has a large number of branched textures 22.

Optionally, the quasi-pyramid structure further includes at least two side edges. The side edge of the quasi-pyramid structure is a common side of adjacent side surfaces in the quasi-pyramid structure. The side edge includes a lower section away from the pyramid vertex 11 and a first section, where a bending degree of the lower section is less than a bending degree of the first section. The bending degree of a sub-section is a degree at which the sub-section is bent. The side edges are in irregular shapes, so that the textured surface has a larger specific surface area, the reflectance is lower, and the light trapping effect is better. Therefore, a short-circuit current may be improved, to finally improve the photoelectric conversion efficiency of the solar cell. In addition, the appearance of the solar cell is in a uniform black color and more beautiful. For example, in FIG. 3, in a left side edge of the leftmost quasi-pyramid structure, the bending degree of a lower section located on the left side of L1 is less than the bending degree of a first section located on the right side of L1. In a rightmost side edge of the leftmost quasi-pyramid structure, a bending degree of a lower section located on the right side of L2 is less than the bending degree of a first section located on the left side of L2.

Optionally, referring to FIG. 3 and FIG. 4, the height fluctuation of the first sub-surface is less than the height fluctuation of the second sub-surface; or the roughness of the first sub-surface is less than the roughness of the second sub-surface. For the height fluctuation and the roughness herein, reference may be made to corresponding records described above. A more irregular shape of the pyramid surface of the quasi-pyramid structure indicates a larger specific surface area of the textured surface, lower reflectance, and a better light trapping effect. Therefore, a short-circuit current may be improved, to finally improve the photoelectric conversion efficiency of the solar cell. In addition, the appearance of the solar cell is in a uniform black color and more beautiful, so that the appearance of the photovoltaic module exhibits a black color almost without color difference and more beautiful. In FIG. 3, for the leftmost quasi-pyramid structure, in the pyramid surface, the height fluctuation of the first sub-surfaces located on the left side of the dashed line L1 and located on the right side of the dashed line L2 is less than the height fluctuation of the second sub-surfaces located between the right side of the dashed line L1 and the left side of the pyramid vertex of the leftmost quasi-pyramid structure and located between the left side of the dashed line L2 and the right side of the pyramid vertex of the leftmost quasi-pyramid structure, or the roughness of the first sub-surfaces located on the left side of the dashed line L1 and located on the right side of the dashed line L2 is less than the roughness of the second sub-surfaces located between the right side of the dashed line L1 and the left side of the pyramid vertex of the leftmost quasi-pyramid structure and located between the left side of the dashed line L2 and the right side of the pyramid vertex of the leftmost quasi-pyramid structure. For the middle quasi-pyramid structure, in the pyramid surface, the height fluctuation of the first sub-surfaces located on the left side of the dashed line L3 and located on the right side of the dashed line L4 is less than the height fluctuation of the second sub-surfaces located between the right side of the dashed line L3 and the left side of the pyramid vertex of the middle quasi-pyramid structure and located between the left side of the dashed line L4 and the right side of the pyramid vertex of the middle quasi-pyramid structure, or the roughness of the first sub-surfaces located on the left side of the dashed line L3 and located on the right side of the dashed line L4 is less than the roughness of the second sub-surfaces located between the right side of the dashed line L3 and the left side of the pyramid vertex of the middle quasi-pyramid structure and located between the left side of the dashed line L4 and the right side of the pyramid vertex of the middle quasi-pyramid structure. For the rightmost quasi-pyramid structure, in the pyramid surface, the height fluctuation of the first sub-surfaces located on the left side of the dashed line L5 and located on the right side of the dashed line L6 is less than the height fluctuation of the second sub-surfaces located between the right side of the dashed line L5 and the left side of the pyramid vertex of the rightmost quasi-pyramid structure and located between the left side of the dashed line L6 and the right side of the pyramid vertex of the rightmost quasi-pyramid structure, or the roughness of the first sub-surfaces located on the left side of the dashed line L5 and located on the right side of the dashed line L6 is less than the roughness of the second sub-surfaces located between the right side of the dashed line L5 and the left side of the pyramid vertex of the rightmost quasi-pyramid structure and located between the left side of the dashed line L6 and the right side of the pyramid vertex of the rightmost quasi-pyramid structure.

Optionally, referring to FIG. 3, the solar cell further includes a passivation anti-reflection layer 3 on the silicon substrate 2. The passivation anti-reflection layer 3 herein may play a passivation function and may further play an anti-reflection function. A material of the passivation anti-reflection layer 3 may be selected from silicon oxide and/or silicon oxynitride, and a specific material of the passivation anti-reflection layer 3 is not limited. The passivation anti-reflection layer 3 may be prepared in a plasma enhanced chemical vapor deposition (PECVD) manner or the like, and a specific preparation manner of the passivation anti-reflection layer 3 is also not specifically limited. The passivation anti-reflection layer 3 includes a first part on the first sub-surface and a second part on the second sub-surface. In the passivation anti-reflection layer 3, a thickness of the first part is greater than a thickness of the second part along the same direction toward the pyramid vertex 21. That is, for comparison between the thickness of the first part and the thickness of the second part, the first part and the second part are pertinent to the same direction towards the pyramid vertex 21. In this specification, the first part and the second part that are along the same direction toward the pyramid vertex 21 may be understood as a first part and a second part sequentially arranged along a direction pointing to the pyramid vertex 21 from a bottom portion or the bottom contour line of the quasi-pyramid structure. A direction along the thickness herein is perpendicular to a tangent at a corresponding position on an outer surface of the passivation anti-reflection layer 3. Specifically, in the silicon substrate 2, a status of a part connected to the quasi-pyramid structure is complex and there are generally a large number of gaps, and a status of a position at which adjacent quasi-pyramid structures are connected is also complex and there are generally a large number of gaps as well. Therefore, a thick passivation anti-reflection layer needs to be arranged at the positions to achieve a good passivation effect, and a thick passivation anti-reflection layer also needs to be arranged on the first sub-surfaces connected to the positions to achieve a good passivation effect. There are a small number of gaps at the pyramid vertex, so that a good passivation effect can be achieved only with a thin passivation anti-reflection layer, and a good passivation effect can also be achieved with a relatively thin passivation anti-reflection layer on the second sub-surface connected to the pyramid vertex. Therefore, in this application, the thickness of the first part is greater than the thickness of the second part along the same direction toward the pyramid vertex. In this way, a good passivation effect can be ensured at each position. In addition, a thickness of the passivation anti-reflection layer is set according to a passivation requirement in this application, so that a waste can be reduced. Meanwhile, in this application, after light enters passivation anti-reflection layers having different thicknesses, an optical path of the light may be changed for more times, so that a light distance may be increased, light absorption may be further improved in cooperation with the textured surface in this application, and the light trapping effect can be better. Therefore, a short-circuit current may be improved, to finally improve the photoelectric conversion efficiency of the solar cell. In addition, the appearance of the solar cell is in a uniform black color and more beautiful. Based on the above, in this application, a good passivation effect is ensured at each position of the solar cell, an anti-reflection effect is greatly improved, and a waste is reduced.

In FIG. 3, for the leftmost quasi-pyramid structure, in the passivation anti-reflection layer 3, a part between the dashed line L1 and the dashed line L2 other than the pyramid vertex 21 is the second part, and parts located on the left side of L1 and located on the right side of L2 are the first part; for the first part and the second part that are along the same direction L7 toward the pyramid vertex 21, the thickness of the first part is greater than the thickness of the second part; and for the first part and the second part that are along the same direction L8 toward the pyramid vertex 21, the thickness of the first part is greater than the thickness of the second part. For the middle quasi-pyramid structure, in the passivation anti-reflection layer 3, a part between the dashed line L3 and the dashed line L4 other than the pyramid vertex 21 is the second part, and parts located on the left side of L3 and located on the right side of L4 are the first part; for the first part and the second part that are along the same direction L9 toward the pyramid vertex, the thickness of the first part is greater than the thickness of the second part; and for the first part and the second part that are along the same direction L10 toward the pyramid vertex, the thickness of the first part is greater than the thickness of the second part. For the rightmost quasi-pyramid structure, in the passivation anti-reflection layer 3, a part between the dashed line L5 and the dashed line L6 other than the pyramid vertex is the second part, and parts located on the left side of L5 and located on the right side of L6 are the first part; for the first part and the second part that are along the same direction L11 toward the pyramid vertex, the thickness of the first part is greater than the thickness of the second part; and for the first part and the second part that are along the same direction L12 toward the pyramid vertex, the thickness of the first part is greater than the thickness of the second part.

It should be noted that, a thickness of a part in the passivation anti-reflection layer 3 may be measured by an instrument such as a transmission electron microscope. The thickness of the part may be an average thickness of the part that is directly measured, or the thickness of the part may be an average thickness obtained by measuring a plurality of points in this part, which may be selected according to the measurability of an actual measurement target and is not specifically limited herein.

Optionally, referring to FIG. 3, in the passivation anti-reflection layer 3, the thickness of the first part is greater than a thickness of a part of the passivation anti-reflection layer 3 at the pyramid vertex 21. Specifically, in the silicon substrate 2, a status of a part connected to the quasi-pyramid structure is complex and there are generally a large number of gaps, and a status of a position at which adjacent quasi-pyramid structures are connected is also complex and there are generally a large number of gaps as well. Therefore, a thick passivation anti-reflection layer needs to be arranged at the positions to achieve a good passivation effect, and a thick passivation anti-reflection layer also needs to be arranged on the first sub-surfaces connected to the positions to achieve a good passivation effect. There are a small number of gaps at the pyramid vertex, so that a good passivation effect can be achieved only with a thin passivation anti-reflection layer. Therefore, in this application, in the passivation anti-reflection layer 3, the thickness of the first part is greater than the thickness of the part of the passivation anti-reflection layer 3 at the pyramid vertex 21. In this way, a good passivation effect can be ensured at each position. In addition, a thickness of the passivation anti-reflection layer is set according to a passivation requirement in this application, so that a waste can be reduced. Meanwhile, in this application, after light enters passivation anti-reflection layers having different thicknesses, an optical path of the light may be changed for more times, so that a light distance may be increased, light absorption may be further improved in cooperation with the textured surface in this application, and the light trapping effect can be better. Therefore, a short-circuit current may be improved, to finally improve the photoelectric conversion efficiency of the solar cell. In addition, the appearance of the solar cell is in a uniform black color and more beautiful.

For example, in FIG. 3, for the leftmost quasi-pyramid structure, the thicknesses of the first parts that are in the passivation anti-reflection layer 3 and located on the left side of the dashed line L1 and on the right side of the dashed line L2 are greater than the thickness of the part at the pyramid vertex 21 of the leftmost quasi-pyramid structure in the passivation anti-reflection layer 3. For the middle quasi-pyramid structure, the thicknesses of the first parts that are in the passivation anti-reflection layer 3 and located on the left side of the dashed line L3 and on the right side of the dashed line L4 are greater than the thickness of the part at the pyramid vertex 21 of the middle quasi-pyramid structure in the passivation anti-reflection layer 3. For the rightmost quasi-pyramid structure, the thicknesses of the first parts that are in the passivation anti-reflection layer 3 and located on the left side of the dashed line L5 and on the right side of the dashed line L6 are greater than the thickness of the part at the pyramid vertex 21 of the rightmost quasi-pyramid structure in the passivation anti-reflection layer 3.

Referring to FIG. 3, a part between the dashed line L2 and the dashed line L3 is a position at which the leftmost quasi-pyramid structure is connected to the middle quasi-pyramid structure, and a part between the dashed line L4 and the dashed line L5 is a position at which the rightmost quasi-pyramid structure is connected to the middle quasi-pyramid structure. Optionally, referring to FIG. 3, in the passivation anti-reflection layer 3, a thickness of a part at the position at which adjacent quasi-pyramid structures are connected is greater than the thickness of the part of the passivation anti-reflection layer 3 at the pyramid vertex 21. Specifically, in the silicon substrate 2, a status of the position at which adjacent quasi-pyramid structures are connected is complex and there are generally a large number of gaps. Therefore, a thick passivation anti-reflection layer needs to be arranged at the position to achieve a good passivation effect. There are a small number of gaps at the pyramid vertex, so that a good passivation effect can be achieved only with a thin passivation anti-reflection layer. Therefore, in this application, in the passivation anti-reflection layer 3, the thickness of the part at the position at which adjacent quasi-pyramid structures are connected is greater than the thickness of the part of the passivation anti-reflection layer 3 at the pyramid vertex 21. In this way, a good passivation effect can be ensured at each position. In addition, a thickness of the passivation anti-reflection layer is set according to a passivation requirement in this application, so that a waste can be reduced. Meanwhile, in this application, after light enters passivation anti-reflection layers having different thicknesses, an optical path of the light may be changed for more times, so that a light distance may be increased, light absorption may be further improved in cooperation with the textured surface in this application, and the light trapping effect can be better. Therefore, a short-circuit current may be improved, to finally improve the photoelectric conversion efficiency of the solar cell. In addition, the appearance of the solar cell is in a uniform black color and more beautiful. For example, in FIG. 3, the thickness of the part between the dashed line L2 and the dashed line L3 in the passivation anti-reflection layer 3 is greater than the thickness of the part at the pyramid vertex 21 of the leftmost quasi-pyramid structure in the passivation anti-reflection layer 3, and is also greater than the thickness of the part at the pyramid vertex 21 of the middle quasi-pyramid structure in the passivation anti-reflection layer 3. In FIG. 3, the thickness of the part between the dashed line L4 and the dashed line L5 in the passivation anti-reflection layer 3 is greater than the thickness of the part at the pyramid vertex of the rightmost quasi-pyramid structure in the passivation anti-reflection layer 3, and is also greater than the thickness of the part at the pyramid vertex of the middle quasi-pyramid structure in the passivation anti-reflection layer 3.

Optionally, referring to FIG. 3, a thickness of a part at the position at which adjacent quasi-pyramid structures are connected in the passivation anti-reflection layer 3 is greater than the thickness of the second part in the passivation anti-reflection layer 3. Specifically, in the silicon substrate 2, a status of the position at which adjacent quasi-pyramid structures are connected is complex and there are generally a large number of gaps. Therefore, a thick passivation anti-reflection layer needs to be arranged at the position to achieve a good passivation effect. There are a small number of gaps at the pyramid vertex, so that a good passivation effect can be achieved only with a thin passivation anti-reflection layer, and a good passivation effect can also be achieved with a relatively thin passivation anti-reflection layer on the second sub-surface connected to the pyramid vertex. Therefore, in this application, in the passivation anti-reflection layer 3, the thickness of the part at the position at which adjacent quasi-pyramid structures are connected is greater than the thickness of the second part of the passivation anti-reflection layer 3. In this way, a good passivation effect can be ensured at each position. In addition, a thickness of the passivation anti-reflection layer is set according to a passivation requirement in this application, so that a waste can be reduced. Meanwhile, in this application, after light enters passivation anti-reflection layers having different thicknesses, an optical path of the light may be changed for more times, so that a light distance may be increased, light absorption may be further improved in cooperation with the textured surface in this application, and the light trapping effect can be better. Therefore, a short-circuit current may be improved, to finally improve the photoelectric conversion efficiency of the solar cell. In addition, the appearance of the solar cell is in a uniform black color and more beautiful.

For example, in FIG. 3, the thickness of the part between the dashed line L2 and the dashed line in the passivation anti-reflection layer 3 is greater than the thickness of the second part between the dashed line L1 and the dashed line L2 other than the pyramid vertex in the passivation anti-reflection layer 3, and is also greater than the thickness of the second part between the dashed line L3 and the dashed line L4 other than the pyramid vertex in the passivation anti-reflection layer 3. In FIG. 3, the thickness of the part between the dashed line L4 and the dashed line L5 in the passivation anti-reflection layer 3 is greater than the thickness of the second part between the dashed line L5 and the dashed line L6 other than the pyramid vertex in the passivation anti-reflection layer 3, and is also greater than the thickness of the second part between the dashed line L3 and the dashed line L4 other than the pyramid vertex in the passivation anti-reflection layer 3.

Optionally, in the passivation anti-reflection layer 3, a thickness non-uniform degree between the first part and the second part is greater than 4%, and the thickness non-uniform degree is: a value obtained by dividing an absolute value of a difference value between a first thickness at a first position in the first part and a second thickness at a second position in the second part along the same direction toward the pyramid vertex by a sum of the first thickness and the second thickness, where the first position in the first part is any position in the first part, and the second position in the second part is any position in the second part. That is, the first part and the second part are pertinent to the same direction toward the pyramid vertex 21, and in the passivation anti-reflection layer 3, the thickness non-uniform degree between the first part and the second part is greater than 4%. Specifically, in the silicon substrate 2, a status of the position at which adjacent quasi-pyramid structures are connected is complex and there are generally a large number of gaps. Therefore, a thick passivation anti-reflection layer needs to be arranged at the position to achieve a good passivation effect. There are a small number of gaps at the pyramid vertex, so that a good passivation effect can be achieved only with a thin passivation anti-reflection layer, and a good passivation effect can also be achieved with a relatively thin passivation anti-reflection layer on the second sub-surface connected to the pyramid vertex. Therefore, in this application, in the passivation anti-reflection layer 3, the thickness non-uniform degree between the first part and the second part is not greater than 4%. In this way, a good passivation effect can be ensured at each position. In addition, a thickness of the passivation anti-reflection layer is set according to a passivation requirement in this application, so that a waste can be reduced. Meanwhile, in this application, after light enters passivation anti-reflection layers having different thicknesses, an optical path of the light may be changed for more times, so that a light distance may be increased, light absorption may be further improved in cooperation with the textured surface in this application, and the light trapping effect can be better. Therefore, a short-circuit current may be improved, to finally improve the photoelectric conversion efficiency of the solar cell. In addition, the appearance of the solar cell is in a uniform black color and more beautiful.

For example, in the passivation anti-reflection layer 3, along the same direction toward the pyramid vertex, the thickness non-uniform degree between the first part and the second part may be 4.001%, 4.03%, 4.09%, 4.2%, 4.31%, 4.5%, 4.9%, 5%, 5.2%, 6%, 7.23%, 8%, 9.2%, 10.3%, 11.2%, 13.46%, 15%, 18%, 20%, 22%, or 25%.

Optionally, the solar cell may further include an aluminum oxide layer (not shown) between the silicon substrate 2 and the passivation anti-reflection layer 3. A fluctuation of the aluminum oxide layer is less than a fluctuation of the passivation anti-reflection layer 3. The fluctuation herein refers to a thickness changing degree, the fluctuation of the aluminum oxide layer may specifically be an absolute value of a difference value between a thickness of the aluminum oxide layer at a fifth position and a thickness of the aluminum oxide layer at a sixth position, and the fluctuation of the passivation anti-reflection layer 3 may specifically be an absolute value of a difference value between a thickness of the passivation anti-reflection layer 3 at a seventh position and a thickness of the passivation anti-reflection layer 3 at an eighth position. In a thickness direction of the silicon substrate, a projection of the fifth position overlaps with a projection of the seventh position, and a projection of the sixth position overlaps with a projection of the eighth position. The sixth position and the sixth position are any two different positions in the aluminum oxide layer. Specifically, the aluminum oxide layer is generally formed through an atom layer deposition process, and a surface morphology has few influence on the atom layer deposition, so that the thickness of the aluminum oxide layer is uniform, and the aluminum oxide layer plays a good passivation function.

It should be noted that, the thickness of the aluminum oxide layer may range from 3 nm to 7 nm, and the thickness of the aluminum oxide layer may also be measured through a transmission electron microscope or the like, which is not specifically limited herein. For example, the fluctuation of the aluminum oxide layer may range from 0.0001 nm to 3 nm, and for example, may be 0.001 nm, 0.005 nm, 0.008 nm, 0.01 nm, 0.02 nm, 0.03 nm, 0.04 nm, 0.05 nm, 0.06 nm, 0.07 nm, 0.08 nm, 0.1 nm, 0.2 nm, 0.3 nm, 0.4 nm, 0.5 nm, 0.6 nm, 0.7 nm, 0.8 nm, 1 nm, 2 nm, 2.3 nm, or 3 nm; and the fluctuation of the passivation anti-reflection layer 3 may range from 3.5 nm to 50 nm, and for example, may be 3.5 nm, 4 nm, 4.8 nm, 6 nm, 7 nm, 8 nm, 9 nm, 10 nm, 12 nm, 12.5 nm, 13 nm, 14 nm, 15 nm, 16 nm, 17 nm, 18 nm, 20 nm, 25 nm, 30 nm, 36 nm, 40 nm, 45 nm, or 50 nm.

Optionally, the thickness of the passivation anti-reflection layer 3 ranges from 60 nm to 70 nm. In this case, the thickness of the passivation anti-reflection layer 3 is appropriate. In this way, a good passivation effect may be ensured at each position. In addition, the thickness of the passivation anti-reflection layer is set according to a passivation requirement in this application, so that a waste can be reduced. Meanwhile, in this application, after light enters passivation anti-reflection layers having different thicknesses, an optical path of the light may be changed for more times, so that a light distance may be increased, light absorption may be further improved in cooperation with the textured surface in this application, and the light trapping effect can be better. Therefore, a short-circuit current may be improved, to finally improve the photoelectric conversion efficiency of the solar cell. In addition, the appearance of the solar cell is in a uniform black color and more beautiful.

The thickness of the passivation anti-reflection layer 3 herein may be a thickness of a front passivation anti-reflection layer on a light receiving side of the silicon substrate 2, and/or a thickness of a back passivation anti-reflection layer on a back side of the silicon substrate 2. For example, the thickness of the front passivation anti-reflection layer may be 60 nm, 60.3 nm, 60.9 nm, 61.4 nm, 61.94 nm, 62.6 nm, 63.9 nm, 64.92 nm, 65.7 nm, 66.9 nm, 67.5 nm, 68.34 nm, or 70 nm.

Optionally, referring to FIG. 5, the pyramid vertex 21 of the quasi-pyramid structure and the second sub-surface of the pyramid surface of the quasi-pyramid structure each include a cluster of quasi-annular textures 23 arranged in a nested manner. The quasi-annular texture 23 herein may be a quasi-annular texture in an open shape and/or a quasi-annular texture in a closed shape. For example, in FIG. 5, in a cluster of quasi-annular textures 23 arranged in a nested manner at a middle position, textures in an open shape and textures in a closed shape both exist. In the cluster of quasi-annular textures 23 arranged in a nested manner, a number of the quasi-annular textures 23 is not specifically limited, and the quasi-annular textures 23 are nested with each other. There is basically no quasi-annular texture in the first sub-surface of the quasi-pyramid structure. There is a correspondence between the quasi-annular textures 23 and the protrusions or depressions on the pyramid surface of the quasi-pyramid structure. The quasi-annular textures 23 are generally located at junctions of the protrusions and the depressions on the pyramid surface of the quasi-pyramid structure. That is, a greater number of quasi-annular textures 23 indicates a greater number of protrusions and depressions on the pyramid surface of the quasi-pyramid structure, and therefore, a greater number of textures indicates a larger specific surface area of the textured surface. More irregular position distribution of the quasi-annular textures indicates a larger specific surface area of the textured surface, lower reflectance, and a better light trapping effect. Therefore, the short-circuit current may be improved, to finally improve the photoelectric conversion efficiency of the solar cell. In addition, the appearance of the solar cell is in a uniform black color and more beautiful.

Referring to FIG. 5, the quasi-annular texture 23 may be a skirt-shaped texture, namely, a skirt-shaped texture that is in an irregular manner stacked and visible to electron microscopy, and/or a rose flower-shaped texture, namely, a texture in a shape of multi-layer stacked rose petals in a rose flower that is in an irregular manner stacked and visible to electron microscopy. Therefore, the quasi-annular texture 23 has a beautiful shape, lower reflectance, and a good light trapping effect.

Optionally, referring to FIG. 5, in a cluster of quasi-annular textures 23, along a height direction of the quasi-pyramid structure, the closer to the pyramid vertex 21, the smaller a contour of the quasi-annular texture 23, and the further away from the pyramid vertex 21, the greater the contour of the quasi-annular texture 23. Position distribution of the quasi-annular textures 23 is irregular. In addition, the quasi-annular textures 23 may increase a specific surface area, so that the textured surface has a larger specific surface area, lower reflectance, and a better light trapping effect. Therefore, a short-circuit current may be improved, to finally improve the photoelectric conversion efficiency of the solar cell. In addition, the appearance of the solar cell is in a uniform black color and more beautiful.

Optionally, referring to FIG. 3 to FIG. 5, a portion in the quasi-pyramid structure away from the pyramid vertex 21 is a lower portion of the quasi-pyramid structure, and a height of the lower portion is at least 1/10 of a height of the quasi-pyramid structure; and in the pyramid surface of the quasi-pyramid structure, the first sub-surface is a region corresponding to the lower portion in the pyramid surface of the quasi-pyramid structure, and the second sub-surface is a region closer to the pyramid vertex 21 than the first sub-surface in the pyramid surface of the quasi-pyramid structure. Specifically, division of the second sub-surface and the first sub-surface is accurate herein, so that preparation of the textured surface is facilitated, and reflectance is lower and a light trapping effect is better. Therefore, a short-circuit current may be improved, to finally improve the photoelectric conversion efficiency of the solar cell. In addition, the appearance of the solar cell is in a uniform black color and more beautiful.

For example, the portion in the quasi-pyramid structure is the lower portion of the quasi-pyramid structure, and the height of the lower portion is 1/10, 2/15, 3/20, 1/9, 1/8, 1/7, 1/6, 1/5, or 1/4 of the height of the quasi-pyramid structure. In the pyramid surface of the quasi-pyramid structure, the first sub-surface is a region corresponding to the lower portion in the pyramid surface of the quasi-pyramid structure, and the second sub-surface is a region closer to the pyramid vertex 21 than the first sub-surface in the pyramid surface of the quasi-pyramid structure.

Optionally, referring to FIG. 5, in the textured surface, lower portions in at least two quasi-pyramid structures away from the pyramid vertexes 21 are integrated. Pyramid vertexes of the quasi-pyramid structures 25 that are integrated are separated from each other, so that the textured surface has a flexible and diversified shape and is easy to prepare, and because the pyramid vertexes of the various quasi-pyramid structures 25 that are integrated are separated from each other, the textured surface has a larger specific surface area, lower reflectance, and a better light trapping effect. Therefore, a short-circuit current may be improved, to finally improve the photoelectric conversion efficiency of the solar cell. In addition, the appearance of the solar cell is in a uniform black color and more beautiful. For example, in FIG. 5, in the textured surface, lower portions in two quasi-pyramid structures enclosed by a left bracket which are at least away from the pyramid vertexes 21 are integrated, and pyramid vertexes of the quasi-pyramid structures 25 are separated from each other.

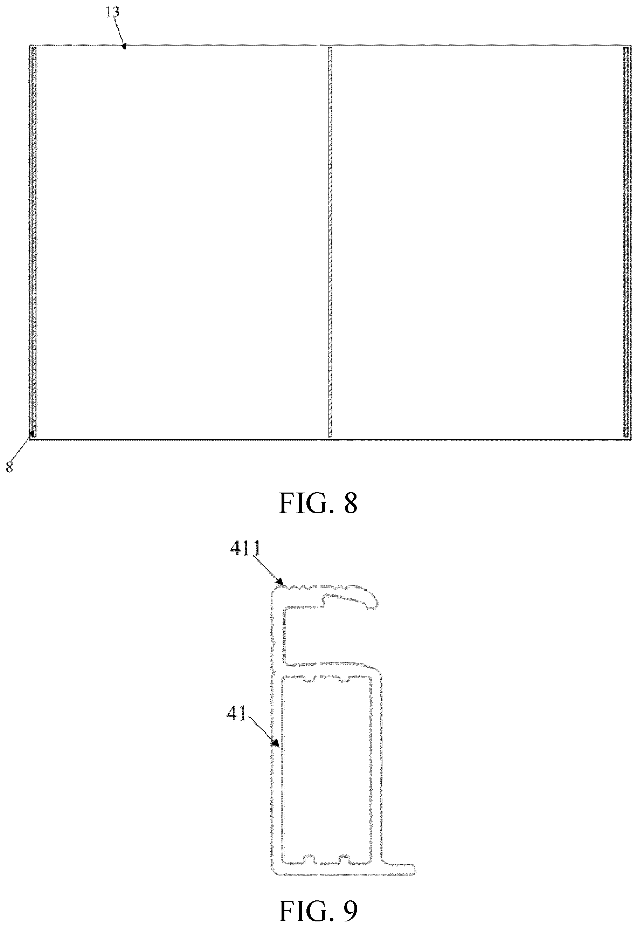

Optionally, referring to FIG. 6 and FIG. 7, the solar cell 4 is a back-contact solar cell, and the solar cell string array further includes a plurality of busbars 15 respectively located at a first end, at a second end, and in a middle portion, where the busbar 15 is mainly configured to electrically connect solar cell strings, and a specific material of the busbar is not specifically limited. The first end is opposite to the second end in an extending direction of the solar cell string, and the middle portion is located between the first end and the second end. A black insulating gasket 9 is adhered to a side of the busbar 15 close to the glass cover 1, and the black insulating gasket 9 totally covers a surface of the busbar 15 close to the glass cover; or referring to FIG. 8, a black blocking object 8 is arranged at a position corresponding to the busbar 15 on the second surface 13 of the glass cover 1. Along a thickness direction of the laminate, a projection of the black blocking object covers a projection of the busbar. The black blocking object includes at least one of black glaze plating, a black adhesive film, or a black tape. Specifically, for the back-contact solar cell, metal electrodes are all arranged on a back surface, and a light receiving surface is not blocked by the metal electrodes, so that the light receiving surface of the back-contact solar cell is basically in a uniform black color and the appearance is more beautiful. Viewing from a light receiving surface of the photovoltaic module or the laminate, along the extending direction of the solar cell string, the plurality of busbars located on the first end, the second end, and the middle portion may be seen, the busbar is generally in a silver white color, and the surface of the busbar is a light receiving surface of the busbar. Therefore, a black insulating gasket is directly adhered to the side of the busbar, and the black insulating gasket totally covers the surface of the busbar; or a black blocking object is arranged at the position corresponding to the busbar on the second surface 13 of the glass cover 1, and along the thickness direction of the laminate, the projection of the black blocking object covers the projection of the busbar, where the black insulating gasket or the black blocking object may totally cover the surface of the busbar. Therefore, viewing from the light receiving surface of the photovoltaic module or the laminate, only the black insulating gasket or the black blocking object can be seen, and the silver white busbar cannot be seen, and viewing from the light receiving surface of the photovoltaic module or the laminate, the photovoltaic module or the laminate exhibits a uniform black color and the appearance is more beautiful, so that the glare problem may also be alleviated. In addition, the metal electrodes of the back-contact solar cell are all arranged on the back surface, and the light receiving surface is not blocked by the metal electrodes, so that incident light is utilized to the greatest extent, an optical loss is reduced, and more effective power generation areas are brought. Therefore, the back-contact solar cell has higher conversion efficiency. In FIG. 8, the black blocking object 8 is still in a black color, and a pink color in the figure is merely used to highlight the black blocking object 8. It should be noted that, colorful lines other than black lines in FIG. 1 to FIG. 13 are only used to display various components in a highlighted manner, and actual colors of the components are mainly described in text.

It should be noted that, that the black insulating gasket totally covers the surface of the busbar or the projection of the black blocking object covers the projection of the busbar along the thickness direction of the laminate herein may be understood as: viewing from the light receiving surface of the photovoltaic module or the laminate, only the black insulating gasket or the black blocking object can be seen, and the busbar cannot be seen.

The black insulating gasket herein has an insulating effect, and does not bring adverse influence on electrical performance of the photovoltaic module or the laminate. The black blocking object herein includes at least one of black glaze plating, a black adhesive film, or a black tape, and the material also has an insulating effect and does not bring adverse influence on the electrical performance of the photovoltaic module or the laminate. In addition, the material has good anti-aging performance and is easy to obtain.

Optionally, the busbar is fixed to an adjacent solar cell through a black tape, so that the busbar does not offset, thereby facilitating accurate positioning and firmly fixing of the busbar. In addition, the black tape matches an overall tone of the photovoltaic module, so that the photovoltaic module is more beautiful.

Optionally, referring to FIG. 6 and FIG. 7, the solar cell 4 is a back-contact solar cell, and the solar cell string array further includes a conductive interconnection member 10 located between adjacent solar cells 4. A function of the conductive interconnection member is mainly to electrically connect adjacent solar cells 4. For example, the conductive interconnection member 10 may be a solder strip or the like, and a specific material thereof is not specifically limited. A black tape 14 is adhered to a side of the conductive interconnection member which is close to the glass cover 1, and the black tape 14 totally covers a surface of the conductive interconnection member which is close to the glass cover 1; or a black blocking object is arranged at a position corresponding to the conductive interconnection member on the second surface of the glass cover. Along the thickness direction of the laminate, a projection of the black blocking object covers a projection of the conductive interconnection member. The black blocking object includes at least one of black glaze plating, a black adhesive film, or a black tape. Specifically, for the back-contact solar cell, metal electrodes are all arranged on a back surface, and a light receiving surface is not blocked by the metal electrodes, so that the light receiving surface of the back-contact solar cell is basically in a uniform black color and the appearance is more beautiful. Most conductive interconnection members are located on a back surface of the back-contact solar cell, viewing from the light receiving surface of the photovoltaic module or the laminate, only the conductive interconnection member may be seen, the conductive interconnection member is generally not in a black color, and the surface of the conductive interconnection member is a light receiving surface of the conductive interconnection member. Therefore, a black tape is directly adhered to the side of the conductive interconnection member, and the black tape totally covers the surface of the conductive interconnection member; or a black blocking object is arranged at the position corresponding to the conductive interconnection member on the second surface 13 of the glass cover 1, and along the thickness direction of the laminate, the projection of the black blocking object covers the projection of the conductive interconnection member, where the black tape or the black blocking object may totally cover the surface of the conductive interconnection member. Therefore, viewing from the light receiving surface of the photovoltaic module or the laminate, only the black tape or the black blocking object can be seen, and the conductive interconnection member cannot be seen, and viewing from the light receiving surface of the photovoltaic module or the laminate, the photovoltaic module or the laminate exhibits a uniform black color and the appearance is more beautiful. In addition, the metal electrodes of the back-contact solar cell are all arranged on the back surface, and the light receiving surface is not blocked by the metal electrodes, so that incident light is utilized to the greatest extent, an optical loss is reduced, and more effective power generation areas are brought. Therefore, the back-contact solar cell has higher conversion efficiency.

It should be noted that, that the black tape totally covers the surface of the conductive interconnection member or the projection of the black blocking object covers the projection of the conductive interconnection member along the thickness direction of the laminate herein may be understood as: viewing from the light receiving surface of the photovoltaic module or the laminate, only the black tape or the black blocking object can be seen, and the conductive interconnection member cannot be seen. The black tape herein also has an insulating effect, and does not bring adverse influence on the electrical performance of the photovoltaic module or the laminate. The black blocking object herein includes at least one of black glaze plating, a black adhesive film, or a black tape, and the material also has an insulating effect and does not bring adverse influence on the electrical performance of the photovoltaic module or the laminate. In addition, the material is easy to obtain. The black tape 14 herein further adheres the conductive interconnection member 10 to the adjacent solar cells 4. Therefore, through slight fusion after lamination, the black tape 14 does not offset and plays a blocking function.

Optionally, a material of the black tape may be selected from polyethylene terephthalate (PET) or polyimide (PI); and/or a glaze of the black glaze plating is selected from at least one of titanium oxide (TiO₂), silicon oxide (SiO₂), aluminum oxide (Al₂O₃), calcium oxide (CaO), zinc oxide (ZnO), magnesium oxide (MgO), or barium oxide (BaO). The foregoing materials have good insulating performance and are easy to obtain.

Optionally, the back sheet is a composite back sheet, and a color of a surface of the composite back sheet close to the solar cell string array is black. Specifically, in a case that the back sheet is a composite back sheet, viewing from the light receiving surface of the photovoltaic module or the laminate, a position corresponding to a gap between every two of the solar cell strings and a position corresponding to a gap between every two of the solar cells on the surface of the composite back sheet may be seen, and a color of the surface of the composite back sheet is black; viewing from the light receiving surface of the photovoltaic module or the laminate, colors of the position corresponding to the gap between every two of the solar cell strings and the position corresponding to the gap between every two of the solar cells on the surface of the composite back sheet are also black; and viewing from the light receiving surface of the photovoltaic module or the laminate, the photovoltaic module or the laminate exhibits a uniform black color, so that the appearance is more beautiful. Alternatively, the back sheet is made of a material including glass, and a black blocking object is arranged at a position corresponding to a gap between every two of the solar cell strings and a position corresponding to a gap between every two of the solar cells on the surface of the back sheet. The black blocking object includes at least one of black glaze plating, a black adhesive film, or a black tape. Specifically, in a case that the back sheet is made of the material including glass, viewing from the light receiving surface of the photovoltaic module or the laminate, a position corresponding to a gap between every two of the solar cell strings and a position corresponding to a gap between every two of the solar cells on a surface of the glass close to the solar cell string array may be seen, and a color of the surface of the glass is black; viewing from the light receiving surface of the photovoltaic module or the laminate, colors of the position corresponding to the gap between every two of the solar cell strings and the position corresponding to the gap between every two of the solar cells on the surface of the glass are also black; and viewing from the light receiving surface of the photovoltaic module or the laminate, the photovoltaic module or the laminate exhibits a uniform black color, so that the appearance is more beautiful. A color of a surface of the composite back sheet away from the solar cell string array is not specifically limited. For example, the color of the surface of the composite back sheet may be white or the like.

It should be noted that, for the black glaze plating, the black adhesive film, and the black tape herein, reference may be made to the foregoing description, and same or similar beneficial effects may be provided. To avoid repetition, details are not described herein again.

Optionally, the photovoltaic module further includes a plurality of black frames located around the laminate. Because the laminate and the frames are all in a black color, viewing from the light receiving surface of the photovoltaic module or the laminate, the photovoltaic module is in a uniform black color, and the appearance is more beautiful. The black frame herein may be a black aluminum alloy frame, a black steel frame, a black composite material frame, or the like, and a material of the black frame is not specifically limited. It should be noted that, a number of the black frames is not specifically limited. For example, the number of the black frames around the laminate may be 4.

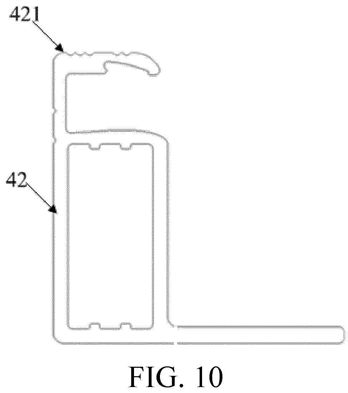

Optionally, referring to FIG. 9 and FIG. 10, a first wave pattern is arranged on a surface A of the black frame. Viewing from an upper part, the black frame respectively includes a surface A, a surface B, and a surface C along an anticlockwise direction. Specifically, the black frame may include a black short frame 41 and/or a black long frame 42, and the first wave pattern may be arranged on a surface A of the black short frame 41 and/or the first wave pattern may be arranged on a surface A of the black long frame 42. The surface A of the black frame may subsequently cooperate with a press block, and the first wave pattern arranged on the surface A of the black frame may increase friction with the press block, so that assembly between the black frame and the press block is firmer and more reliable.

Optionally, an arc-shaped chamfer is arranged at each corner of the photovoltaic module. The arc-shaped chamfer is arc-shaped, so that stress concentration may be avoided, and a person may be prevented from being cut by the arc-shaped chamfer.

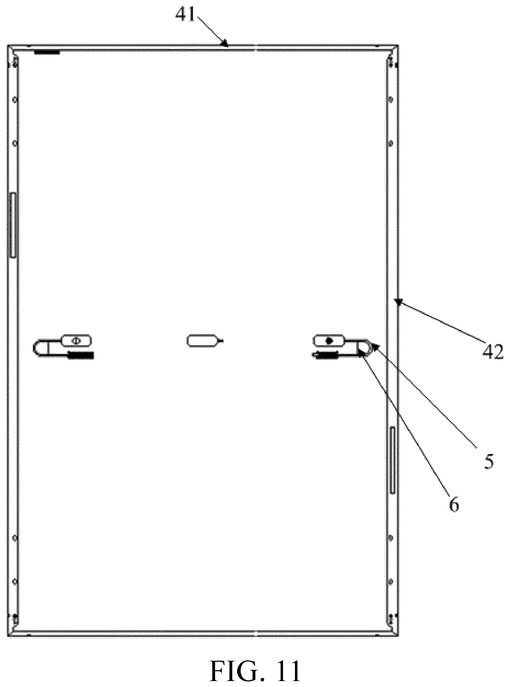

Optionally, referring to FIG. 11, the photovoltaic module may further include a junction box 5 located on a side of the back sheet away from the solar cell string array and a black cable tie 6 configured to tie the junction box 5 and other lines surrounding the junction box 5. The black cable tie 6 matches an overall color of the photovoltaic module, so that the appearance of the photovoltaic module is more beautiful. The foregoing busbars may be converged into the junction box 5. A function of black cable tie 6 is mainly to tie the junction box 5 and other lines surrounding the junction box.

Optionally, a black sealant is arranged between the laminate and the black frame, and a main function of the black sealant is to fill a gap between the laminate and the black frame. The sealant is also in a black color and matches the overall color of the photovoltaic module, so that the appearance of the photovoltaic module is in a uniform black and more beautiful.

Optionally, the black cable tie 6 is a black detachable cable tie, where a slipknot cable tie is easy to disassemble, and may be used to resolve a problem of being difficult to disassemble during on-site mounting and may be repeatedly used.

Optionally, a second wave pattern matching the foregoing first wave pattern is arranged on the press block cooperating with the black frame. Through cooperation between the first wave pattern and the second wave pattern, friction between the black frame and the press block may be increased, so that assembly between the black frame and the press block is firmer and more reliable.

Optionally, at least one of four frames located around the laminate is an anti-dust frame without a surface A, which may reduce dust accumulation. A number of anti-dust frames without a surface A in the four frames located around the laminate is not limited. For example, one short frame in the four frames may be an anti-dust frame without a surface A, and after the photovoltaic module is mounted, the anti-dust frame without a surface A is closer to the ground, playing a good anti-dust function. Alternatively, the four frames are all anti-dust frames without a surface A, so that the four frames have good consistency and are more beautiful.

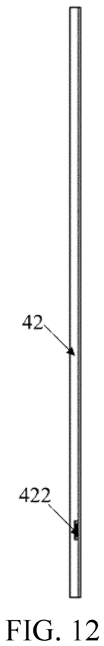

Optionally, referring to FIG. 12, a laser nameplate 422 is arranged on a surface B and/or a surface C of the black frame, and for the surface B and/or the surface C of the black frame, reference may be made to the foregoing description. The laser nameplate 422 herein may record identification information such as frame barcode, the surface B and/or the surface C of the black frame is more concealed than the surface A, and space multiplexing is implemented by arranging the laser nameplate 422 on the surface B and/or the surface C of the black frame.

Optionally, referring to FIG. 6, each of the solar cell strings includes 9 solar cells 4 connected in series, and the solar cell string array is a 6×2 solar cell string array. In other words, the photovoltaic module is a 54-type photovoltaic module, internal space of the photovoltaic module can be effectively utilized by the solar cell string array, and the photovoltaic module has exsolar cellent electrical performance.

Optionally, a width d2 of the photovoltaic module ranges from 1127 mm to 1138 mm, and a length d3 of the photovoltaic module ranges from 1716 mm to 2400 mm. The length of the photovoltaic module is perpendicular to the extending direction of the solar cell string, and the width of the photovoltaic module is parallel to the extending direction of the solar cell string. A size of the photovoltaic module is appropriate, and the electrical performance is excellent.

For example, the width d2 of the photovoltaic module may be 1127 mm, 1127.11 mm, 1127.5 m, 1128 mm, 1128.5 mm, 1128.97 mm, 1129 mm, 1129.5 mm, 1129.9 mm, 1130 mm, 1130.5 mm, 1131 mm, 1131.5 mm, 1132 mm, 1132.5 mm, 1133 mm, 1133.5 mm, 1134 mm, 1134.5 mm, 1135 mm, 1135.5 mm, 1136 mm, 1136.5 mm, 1137 mm, 1137. 5 mm, or 1138 mm.

In another example, the length d3 of the photovoltaic module may be 1716 mm, 1718 mm, 1719 mm, 1720 mm, 1720.5 mm, 1725 mm, 1730 mm, 1735.5 mm, 1740 mm, 1745.5 mm, 1750 mm, 1760.5 mm, 1780 mm, 1781.5 mm, 1792 mm, 1796.5 mm, 1799 mm, 1800 mm, 1802 mm, 1803.5 mm, 1804 mm, 1820 mm, 1849 mm, 1890 mm, 1900 mm, 1924 mm, 1948 mm, 1960 mm, 2002 mm, 2180 mm, 2300 mm, 2324 mm, or 2400 mm.

Optionally, referring to FIG. 13, the back sheet 7 is made of a material including glass, and a part of the back sheet is presented herein. A through-hole 71 is provided on the back sheet 7, and a black blocking object 8 is arranged on a surface of the back sheet 7 close to the solar cell string array and around the through-hole 71. Color difference exists between the junction box 5 located on a side of the back sheet 7 away from the solar cell string array and the light receiving surface of the photovoltaic module. The black blocking object 8 herein may play a function of blocking a part of the junction box 5 that is exposed. Therefore, viewing from the light receiving surface of the photovoltaic module or the laminate, the photovoltaic module is in a uniform black color and the appearance is more beautiful.

It should be noted that, the pink color in FIG. 13 is only used to highlight the black blocking object 8 and is not an actual color of the black blocking object 8, where the black blocking object 8 is still in a black color. A shape of the through-hole 71 and a hole diameter d4 are not specifically limited. For example, the through-hole 71 may be a circular through-hole or an elliptical through-hole, and the shape of the through-hole 71 and the hole diameter d4 are both set for the busbars to run through. A distance d5 between the black blocking object 8 around the through-hole 71 and the through-hole 71 may range from 0 mm to 2.3 mm. When the distance d5 between the black blocking object 8 around the through-hole 71 and the through-hole 71 is 0 mm, it indicates that the black blocking object 8 is arranged at an edge of the through-hole 71. The distance d5 between the black blocking object 8 around the through-hole 71 and the through-hole 71 ranges from 0 mm to 2.3 mm. The distance d5 is set to a suitable value, so that the part of the junction box 5 that is exposed may be totally blocked, and no waste is caused. A shape of a portion of the black blocking object close to the through-hole 71 is consistent with the shape of the through-hole 71, so that better aesthetics may be achieved. For example, in FIG. 13, the through-hole 71 is a circular hole and a hole diameter thereof is d4, the shape of the portion of the black blocking object 8 is also circular with a hole diameter d6, where a difference value between d6 and d4 is d5.

For example, the distance d5 between the black blocking object 8 around the through-hole 71 and the through-hole 71 may be 0 mm, 0.11 mm, 0.27 mm, 0.69 mm, 0.73 mm, 0.97 mm, 1 mm, 1.13 mm, 1.29 mm, 1.33 mm, 1.47 mm, 1.51 mm, 1.65 mm, 1.72 mm, 1.83 mm, 1.94 mm, 2 mm, 2.1 mm, 2.2 mm, 2.26 mm, or 2.3 mm.

This application further provides a photovoltaic system. The photovoltaic system includes a plurality of photovoltaic modules according to any one of the foregoing descriptions arranged in an array. An arrangement manner, an arrangement position, and the like of the photovoltaic system are not specifically limited. The photovoltaic system and the photovoltaic module according to any one of the foregoing description have the same or similar beneficial effects, and mutual reference may be made for related parts. To avoid repetition, details are not described herein again.

The embodiments of the present disclosure are described above with reference to the accompanying drawings. However, the present disclosure is not limited to the foregoing specific implementations, and the foregoing specific implementations are only exemplary rather than limitative. A person of ordinary skill in the art may further make, under the teaching of the present disclosure, many forms without departing from the scope of the claims.

## Claims

1. A photovoltaic module, comprising: a laminate, wherein
the laminate comprises:
a solar cell string array, comprising a plurality of solar cell strings arranged in an array, wherein each of the solar cell strings comprises a plurality of electrically connected solar cells (4), and a glass cover (1), located on a first side of the solar cell string array, wherein a first surface (11) of the glass cover (1) away from the solar cell string array has a plurality of concave-convex structures (12), and a back sheet (7), located on a second side of the solar cell string array, wherein the first side is opposite to the second side,
**characterized in that**
the average reflectance of each of the solar cells (4) ranges from 2.4% to 2.9%;
a flatness of a second surface (13) of the glass cover (1) close to the solar cell string array is less than a flatness of the first surface (11), wherein the flatness is defined as the difference between unevenness and absolute evenness, and a smaller value of the flatness indicates a flatter surface;
a ratio of a height to a width of the concave-convex structure (12) ranges from 0.6 to 1.8, a direction along the height of the concave-convex structure (12) is parallel to a direction along a thickness of the laminate, and a direction along the width of the concave-convex structure (12) is perpendicular to the direction along the thickness of the laminate and **in that** the width and the height of the concave-convex structure (12) ranges from 1.5 µm to 2.5 µm.

2. The photovoltaic module according to claim 1, wherein the plurality of concave-convex structures (12) have peaks (121) distributed in an array or distributed in an irregular manner.

3. The photovoltaic module according to claim 1, wherein the glass cover (1) is patterned glass; and the second surface (13) of the glass cover (1) is a smooth surface.

4. The photovoltaic module according to claim 1, wherein a range of reflectance of each of the solar cells (4) is from 0.23% to 24%.

5. The photovoltaic module according to claim 1, wherein the solar cell (4) comprises: a silicon substrate (2), wherein a surface of the silicon substrate (2) has a textured surface, the textured surface comprises a plurality of quasi-pyramid structures, each of the plurality of quasi-pyramid structures comprises a pyramid surface and a pyramid vertex (21) , the pyramid surface of the quasi-pyramid structure comprises a first sub-surface away from the pyramid vertex (2) and a second sub-surface, and the second sub-surface is a remaining portion other than the first sub-surface in the pyramid surface of the quasi-pyramid structure; and
on the pyramid surface of the quasi-pyramid structure, a surface morphology of the first sub-surface is different from a surface morphology of the second sub-surface; or
the pyramid surface of the quasi-pyramid structure comprises branched textures (22) , and a number of branched textures (22) in the second sub-surface is greater than a number of branched textures (22) in the first sub-surface; or
the quasi-pyramid structure further comprises at least two side edges, wherein the side edge comprises a lower section away from the pyramid vertex (21) and a first section, and a bending degree of the lower section is less than a bending degree of the first section.

6. The photovoltaic module according to claim 5, wherein
a height fluctuation of the first sub-surface is less than a height fluctuation of the second sub-surface; or
a roughness of the first sub-surface is less than a roughness of the second sub-surface.

7. The photovoltaic module according to claim 5 or 6, wherein the solar cell (4) further comprises a passivation anti-reflection layer (3) on the silicon substrate (2); the passivation anti-reflection layer (3) comprises a first part on the first sub-surface and a second part on the second sub-surface; in the passivation anti-reflection layer (3), a thickness of the first part is greater than a thickness of the second part along the same direction toward the pyramid vertex (21) ; and/or
a thickness of the passivation anti-reflection layer (3) ranges from 60 nm to 70 nm.

8. The photovoltaic module according to any one of claims 1 to 6, wherein the solar cell (4) is a back-contact solar cell, and the solar cell string array further comprises: a plurality of busbars (15) respectively located at a first end, at a second end, and in a middle portion, wherein the first end is opposite to the second end in an extending direction of the solar cell string, and the middle portion is located between the first end and the second end;
a black insulating gasket (9) is adhered to a side of the busbar (15) close to the glass cover (1), the black insulating gasket (9) totally covers a surface of the busbar (15) close to the glass cover (1), and the busbar (15) is fixed to an adjacent solar cell (4) through a black tape (14); or
a black blocking object (8) is arranged at a position corresponding to the busbar (15) on the second surface (13) of the glass cover (1), a projection of the black blocking object (8) covers a projection of the busbar (15) along a thickness direction of the laminate, and the black blocking object (8) comprises at least one of black glaze plating, a black adhesive film, or a black tape (14).

9. The photovoltaic module according to any one of claims 1 to 6, wherein the solar cell (4) is a back-contact solar cell, and the solar cell string array further comprises: a conductive interconnection member (10) located between adjacent solar cells (4);
a black tape (14) is adhered to a side of the conductive interconnection member (10) which is close to the glass cover (1), and the black tape (14) totally covers a surface of the conductive interconnection member (10) which is close to the glass cover (1); or
a black blocking object (8) is arranged at a position corresponding to the conductive interconnection member (10) on the second surface (13) of the glass cover (1), a projection of the black blocking object (8) covers a projection of the conductive interconnection member (10) along a thickness direction of the laminate, and the black blocking object (8) comprises at least one of black glaze plating, a black adhesive film, or a black tape (14).

10. The photovoltaic module according to any one of claims 1 to 6, wherein the back sheet (7) is a composite back sheet (7), and a color of a surface of the composite back sheet (7) close to the solar cell string array is black; or
the back sheet (7) is made of a material comprising glass, a black blocking object (8) is arranged at a position corresponding to a gap between every two of the solar cell strings and a position corresponding to a gap between every two of the solar cells (4) on a surface of the back sheet (7) close to the solar cell string array, and the black blocking object (8) comprises at least one of black glaze plating, a black adhesive film, or a black tape (14).

11. The photovoltaic module according to any one of claims 1 to 7, wherein the photovoltaic module further comprises: a plurality of black frames located around the laminate, wherein a first wave pattern is arranged on a surface A of the black frame; and/or
an arc-shaped chamfer is arranged at each corner of the photovoltaic module; and/or
the photovoltaic module further comprises a junction box (5) located on a side of the back sheet (7) away from the solar cell string array and a black cable tie (6) configured to tie the junction box (5) and other lines surrounding the junction box (5).

12. The photovoltaic module according to claim 10, wherein the back sheet (7) is made of the material comprising glass, a through-hole (71) is provided on the back sheet (7), the black blocking object (8) is arranged on the surface of the back sheet (7) and around the through-hole (71), a distance between the black blocking object (8) arranged around the through-hole (71) and the through-hole (71) ranges from 0 mm to 2.3 mm, and a shape of a portion of the block blocking object close to the through-hole (71) is consistent with a shape of the through-hole (71).

13. A photovoltaic system, comprising a plurality of photovoltaic modules according to any one of claims 1 to 12 arranged in an array.

## Patentansprüche

1. Fotovoltaisches Modul, umfassend: ein Laminat, wobei
das Laminat umfasst:
eine Solarzellenstranganordnung, umfassend eine Vielzahl von Solarzellensträngen, die in einer Anordnung angeordnet sind, wobei jeder der Solarzellenstränge eine Vielzahl von elektrisch verbundenen Solarzellen (4) umfasst, und eine Glasabdeckung (1), die sich auf einer ersten Seite der Solarzellenstranganordnung befindet, wobei eine erste Oberfläche (11) der Glasabdeckung (1), die von der Solarzellenstranganordnung entfernt ist, eine Vielzahl von konkav-konvexen Strukturen (12) aufweist, und eine Rückseitenfolie (7), die sich auf einer zweiten Seite der Solarzellenstranganordnung befindet, wobei die erste Seite der zweiten Seite gegenüberliegt,
**dadurch gekennzeichnet, dass**
der durchschnittliche Reflexionsgrad der einzelnen Solarzellen (4) zwischen 2,4 % und 2,9 % liegt;
eine Planheit einer zweiten Oberfläche (13) der Glasabdeckung (1) in der Nähe der Solarzellenstranganordnung geringer ist als eine Planheit der ersten Oberfläche (11), wobei die Planheit als die Differenz zwischen Unebenheit und absoluter Ebenheit definiert ist und ein kleinerer Wert der Planheit eine flachere Oberfläche anzeigt;
ein Verhältnis einer Höhe zu einer Breite der konkav-konvexen Struktur (12) im Bereich von 0,6 bis 1,8 liegt, eine Richtung entlang der Höhe der konkav-konvexen Struktur (12) parallel zu einer Richtung entlang einer Dicke des Laminats ist, und eine Richtung entlang der Breite der konkav-konvexen Struktur (12) senkrecht zu der Richtung entlang der Dicke des Laminats ist und **dadurch,** dass
die Breite und die Höhe der konkav-konvexen Struktur (12) zwischen 1,5 µm und 2,5 µm liegen.

2. Fotovoltaisches Modul nach Anspruch 1, wobei die Vielzahl von konkav-konvexen Strukturen (12) Spitzen (121) aufweist, die in einer Anordnung oder in unregelmäßiger Weise verteilt sind.

3. Fotovoltaisches Modul nach Anspruch 1, wobei die Glasabdeckung (1) strukturiertes Glas ist; und die zweite Oberfläche (13) der Glasabdeckung (1) eine glatte Oberfläche ist.

4. Fotovoltaisches Modul nach Anspruch 1, wobei der Reflexionsbereich jeder der Solarzellen (4) zwischen 0,23 % und 24 % liegt.

5. Fotovoltaisches Modul nach Anspruch 1, wobei die Solarzelle (4) umfasst: ein Siliziumsubstrat (2), wobei eine Oberfläche des Siliziumsubstrats (2) eine texturierte Oberfläche aufweist, die texturierte Oberfläche eine Vielzahl von Quasi-Pyramidenstrukturen umfasst, jede der Vielzahl von Quasi-Pyramidenstrukturen eine Pyramidenoberfläche und einen Pyramidenscheitel (21) umfasst, die Pyramidenoberfläche der Quasi-Pyramidenstruktur eine erste Teiloberfläche, die von dem Pyramidenscheitel (2) entfernt ist, und eine zweite Teiloberfläche umfasst, und die zweite Teiloberfläche ein verbleibender Abschnitt ist, der von der ersten Teiloberfläche in der Pyramidenoberfläche der Quasi-Pyramidenstruktur verschieden ist; und
auf der Pyramidenoberfläche der Quasi-Pyramidenstruktur eine Oberflächenmorphologie der ersten Teiloberfläche von einer Oberflächenmorphologie der zweiten Teiloberfläche verschieden ist; oder
die Pyramidenoberfläche der Quasi-Pyramidenstruktur verzweigte Texturen (22) umfasst, und eine Anzahl verzweigter Texturen (22) in der zweiten Teiloberfläche größer ist als eine Anzahl verzweigter Texturen (22) in der ersten Teiloberfläche; oder
die Quasi-Pyramidenstruktur des Weiteren mindestens zwei Seitenkanten umfasst, wobei die Seitenkante einen unteren Abschnitt, der von dem Pyramidenscheitel (21) entfernt ist, und einen ersten Abschnitt umfasst, und ein Biegegrad des unteren Abschnitts geringer ist als ein Biegegrad des ersten Abschnitts.

6. Fotovoltaisches Modul nach Anspruch 5, wobei
eine Höhenschwankung der ersten Teiloberfläche geringer ist als eine Höhenschwankung der zweiten Teiloberfläche; oder
eine Rauigkeit der ersten Teiloberfläche geringer ist als eine Rauigkeit der zweiten Teiloberfläche.

7. Fotovoltaisches Modul nach Anspruch 5 oder 6, wobei die Solarzelle (4) des Weiteren eine Passivierungs-Antireflexionsschicht (3) auf dem Siliziumsubstrat (2) umfasst; die Passivierungs-Antireflexionsschicht (3) einen ersten Teil auf der ersten Teiloberfläche und einen zweiten Teil auf der zweiten Teiloberfläche umfasst; in der Passivierungs-Antireflexionsschicht (3) eine Dicke des ersten Teils größer ist als eine Dicke des zweiten Teils entlang der gleichen Richtung zu dem Pyramidenscheitel (21) hin; und/oder
eine Dicke der Passivierungs-Antireflexionsschicht (3) von 60 nm bis 70 nm reicht.

8. Fotovoltaisches Modul nach einem der Ansprüche 1 bis 6, wobei die Solarzelle (4) eine Rückkontaktsolarzelle ist und die Solarzellenstranganordnung des Weiteren umfasst:
eine Vielzahl von Stromschienen (15), die jeweils an einem ersten Ende, an einem zweiten Ende und in einem mittleren Abschnitt angeordnet sind, wobei das erste Ende dem zweiten Ende in einer Erstreckungsrichtung des Solarzellenstrangs gegenüberliegt und der mittlere Abschnitt zwischen dem ersten Ende und dem zweiten Ende angeordnet ist;
eine schwarze isolierende Dichtung (9) an eine Seite der Stromschiene (15) nahe der Glasabdeckung (1) geklebt ist, die schwarze isolierende Dichtung (9) eine Oberfläche der Stromschiene (15) nahe der Glasabdeckung (1) vollständig bedeckt und die Stromschiene (15) durch ein schwarzes Band (14) an einer benachbarten Solarzelle (4) fixiert ist; oder
ein schwarzes blockierendes Objekt (8) an einer mit der Stromschiene (15) korrespondierenden Position auf der zweiten Oberfläche (13) der Glasabdeckung (1) angeordnet ist, ein Vorsprung des schwarzen blockierenden Objekts (8) einen Vorsprung der Stromschiene (15) entlang einer Dickenrichtung des Laminats bedeckt und das schwarze blockierende Objekt (8) mindestens eines aus einer schwarzen Glasur, einem schwarzen Klebefilm oder einem schwarzen Band (14) umfasst.

9. Fotovoltaisches Modul nach einem der Ansprüche 1 bis 6, wobei die Solarzelle (4) eine Rückkontaktsolarzelle ist und die Solarzellenstranganordnung des Weiteren umfasst:
ein leitendes Zwischenverbindungselement (10), das zwischen benachbarten Solarzellen (4) angeordnet ist;
ein schwarzes Band (14) auf eine Seite des leitenden Zwischenverbindungselements (10) geklebt ist, die der Glasabdeckung (1) nahe ist, und das schwarze Band (14) eine Oberfläche des leitenden Zwischenverbindungselements (10), die der Glasabdeckung (1) nahe ist, vollständig bedeckt; oder
ein schwarzes blockierendes Objekt (8) an einer mit dem leitenden Zwischenverbindungselement (10) korrespondierenden Position auf der zweiten Oberfläche (13) der Glasabdeckung (1) angeordnet ist, ein Vorsprung des schwarzen blockierenden Objekts (8) einen Vorsprung des leitenden Zwischenverbindungselements (10) entlang einer Dickenrichtung des Laminats bedeckt und das schwarze blockierende Objekt (8) mindestens eines aus einer schwarzen Glasur, einem schwarzen Klebefilm oder einem schwarzen Band (14) umfasst.

10. Fotovoltaisches Modul nach einem der Ansprüche 1 bis 6, wobei die Rückseitenfolie (7) eine Verbundrückseitenfolie (7) ist und eine Farbe einer Oberfläche der Verbundrückseitenfolie (7) in der Nähe der Solarzellenstranganordnung schwarz ist; oder
die Rückseitenfolie (7) aus einem Material besteht, das Glas umfasst, ein schwarzes blockierendes Objekt (8) an einer mit einer Lücke zwischen jeweils zwei der Solarzellenstränge korrespondierenden Position und an einer mit einer Lücke zwischen jeweils zwei der Solarzellen (4) korrespondierenden Position auf einer Oberfläche der Rückseitenfolie (7) nahe der Solarzellenstranganordnung angeordnet ist, und das schwarze blockierende Objekt (8) mindestens eines aus einer schwarzen Glasur, einem schwarzen Klebefilm oder einem schwarzen Band (14) umfasst.

11. Fotovoltaisches Modul nach einem der Ansprüche 1 bis 7, wobei das fotovoltaische Modul des Weiteren umfasst: eine Vielzahl von schwarzen Rahmen, die um das Laminat herum angeordnet sind, wobei ein erstes Wellenmuster auf einer Oberfläche A des schwarzen Rahmens angeordnet ist; und/oder
an jeder Ecke des fotovoltaischen Moduls eine bogenförmige Abschrägung angeordnet ist; und/oder
das fotovoltaische Modul des Weiteren eine Anschlussdose (5) umfasst, die sich auf einer von der Solarzellenstranganordnung abgewandten Seite der Rückseitenfolie (7) befindet, und einen schwarzen Kabelbinder (6), der dazu konfiguriert ist, die Anschlussdose (5) und andere die Anschlussdose (5) umgebende Leitungen zu binden.

12. Fotovoltaisches Modul nach Anspruch 10, wobei die Rückseitenfolie (7) aus dem Material hergestellt ist, das Glas umfasst, ein Durchgangsloch (71) auf der Rückseitenfolie (7) vorgesehen ist, das schwarze blockierende Objekt (8) auf der Oberfläche der Rückseitenfolie (7) und um das Durchgangsloch (71) herum angeordnet ist, eine Distanz zwischen dem um das Durchgangsloch (71) herum angeordneten schwarzen blockierenden Objekt (8) und dem Durchgangsloch (71) im Bereich von 0 mm bis 2,3 mm liegt, und eine Form eines Abschnitts des schwarzen blockierenden Objekts nahe dem Durchgangsloch (71) mit einer Form des Durchgangslochs (71) übereinstimmt.

13. Fotovoltaisches System, das eine Vielzahl von fotovoltaischen Modulen nach einem der Ansprüche 1 bis 12 umfasst, die in einer Anordnung angeordnet sind.

## Revendications

1. Module photovoltaïque comprenant : un stratifié, dans lequel
le stratifié comprend :
un réseau de chaînes de cellules solaires, comprenant une pluralité de chaînes de cellules solaires agencées en un réseau, dans lequel chaque chaîne de cellules solaires comprenant une pluralité de cellules solaires connectées électriquement (4), et
un recouvrement en verre (1), située sur un premier côté du réseau de chaînes de cellules solaires, dans lequel une première surface (1) du recouvrement en verre à l'opposé du réseau de chaînes de cellules solaires présente une pluralité de structures concaves-convexes (12), et une feuille arrière (7), située sur un second côté du réseau de chaînes de cellules solaires, dans lequel le premier côté est opposé au second côté,
**caractérisé en ce que**
le facteur de réflexion moyenne de chacune des cellules solaires (4) est compris entre 2,4 % et 2,9 % ;
une planéité d'une seconde surface (13) du recouvrement en verre (1) à proximité du réseau de chaînes de cellules solaires est inférieure à une planéité de la première surface (11), dans lequel la planéité est définie comme la différence entre une irrégularité et une planéité absolue, et une valeur plus petite de la planéité indique une surface plus plate ;
un rapport d'une hauteur sur une largeur de la structure concave-convexe (12) est compris entre 0,6 et 1,8, une direction le long de la hauteur de la structure concave-convexe (12) est parallèle à une direction le long d'une épaisseur du stratifié, et une direction le long de la largeur de la structure concave-convexe est perpendiculaire à la direction le long de l'épaisseur du stratifié, et **en ce que**
la largeur et la hauteur de la structure concave-convexe (12) sont dans la plage allant de 1,5 µm à 2,5 µm.

2. Module photovoltaïque selon la revendication 1, dans lequel la pluralité de structures concaves-convexes (12) présentent des pics (121) distribués dans un réseau ou distribués de manière irrégulière.

3. Module photovoltaïque selon la revendication 1, dans lequel le recouvrement en verre (1) est en verre à motifs ; et la seconde surface (13) du recouvrement en verre (1) est une surface lisse.

4. Module photovoltaïque selon la revendication 1, dans lequel une plage de facteur de réflexion de chacune des cellules solaires (4) va de 0,23 % à 24 %.

5. Module photovoltaïque selon la revendication 1, dans lequel la cellule solaire (4) comprend : un substrat de silicium (2), dans lequel une surface du substrat de silicium (2) présente une surface texturée, la surface texturée comprend une pluralité de structures quasi-pyramidales, chacune de la pluralité de structures quasi-pyramidales comprend une surface pyramidale et un sommet pyramidal (21), la surface pyramidale de la structure quasi-pyramidale comprend une première sous-surface à l'opposé du sommet pyramidal (2) et une seconde sous-surface, et la seconde sous-surface est une partie restante autre que la première sous-surface dans la surface pyramidale de la structure quasi-pyramidale ; et
sur la surface pyramidale de la structure quasi-pyramidale, une morphologie de surface de la première sous-surface est différente d'une morphologie de surface de la seconde sous-surface ; ou
la surface pyramidale de la structure quasi-pyramidale comprend des textures ramifiées (22), et
un nombre de textures ramifiées (22) dans la seconde sous-surface est supérieur à un nombre de textures ramifiées (22) dans la première sous-surface ; ou
la structure quasi-pyramidale comprend en outre au moins deux bords latéraux, dans lequel le bord latéral comprend une section inférieure à l'opposé du sommet pyramidal (21) et une première section, et un degré de flexion de la section inférieure est inférieur à un degré de flexion de la première section.

6. Module photovoltaïque selon la revendication 5, dans lequel
une fluctuation de hauteur de la première sous-surface est inférieure à une fluctuation de hauteur de la seconde sous-surface ; ou
une rugosité de la première sous-surface est inférieure à une rugosité de la seconde sous-surface.

7. Module photovoltaïque selon la revendication 5 ou 6, dans lequel la cellule solaire (4) comprend en outre une couche antireflet de passivation (3) sur le substrat de silicium (2) ; la couche antireflet de passivation (3) comprend une première partie sur la première sous-surface et une seconde partie sur la seconde sous-surface ; dans la couche antireflet de passivation (3), une épaisseur de la première partie est supérieure à une épaisseur de la seconde partie le long de la même direction vers le sommet pyramidal (21) ; et/ou
une épaisseur de la couche antireflet de passivation (3) est dans la plage allant de 60 nm à 70 nm.

8. Module photovoltaïque selon l'une quelconque des revendications 1 à 6, dans lequel la cellule solaire (4) est une cellule solaire à contact arrière, et le réseau de chaînes de cellules solaires comprend en outre : une pluralité de barres omnibus (15) situées respectivement à une première extrémité, à une seconde extrémité, et dans une partie médiane, dans lequel la première extrémité est opposée à la seconde extrémité dans une direction d'extension de la chaîne de cellules solaires, et la partie médiane est située entre la première extrémité et la seconde extrémité ;
un joint isolant noir (9) est mis en adhérence sur un côté de la barre omnibus (15) à proximité du recouvrement en verre (1), le joint isolant noir (9) recouvre totalement une surface de la barre omnibus (15) à proximité du recouvrement en verre (1), et la barre omnibus (15) est fixée à une cellule solaire adjacente (4) à travers un ruban noir (14) ; ou
un objet de blocage noir (8) est agencé dans une position correspondant à la barre omnibus (15) sur la seconde surface (13) du recouvrement en verre (1), une projection de l'objet de blocage noir (8) recouvre une projection de la barre omnibus (15) le long d'une direction d'épaisseur du stratifié, et l'objet de blocage noir (8) comprend au moins un élément parmi un placage de glaçure noire, un film adhésif noir ou un ruban noir (14).

9. Module photovoltaïque selon l'une quelconque des revendications 1 à 6, dans lequel la cellule solaire (4) est une cellule solaire à contact arrière, et le réseau de chaînes de cellules solaires comprend en outre : un élément d'interconnexion conducteur (10) situé entre des cellules solaires adjacentes (4) ;
un ruban noir (14) est mis en adhérence sur un côté de l'élément d'interconnexion conducteur (10) qui est proche du recouvrement en verre (1), et le ruban noir (14) recouvre totalement une surface de l'élément d'interconnexion conducteur (10) qui est proche du recouvrement en verre (1) ; ou
un objet de blocage noir (8) est agencé dans une position correspondant à l'élément d'interconnexion conducteur (10) sur la seconde surface (13) du recouvrement en verre (1), une projection de l'objet de blocage noir (8) recouvre une projection de l'élément d'interconnexion conducteur (10) le long d'une direction d'épaisseur du stratifié, et l'objet de blocage noir (8) comprend au moins un élément parmi un placage de glaçure noire, un film adhésif noir ou un ruban noir (14).

10. Module photovoltaïque selon l'une quelconque des revendications 1 à 6, dans lequel la feuille arrière (7) est une feuille arrière composite (7), et une couleur d'une surface de la feuille arrière composite (7) à proximité du réseau de chaînes de cellules solaires est noire ; ou
la feuille arrière (7) est constituée d'un matériau comprenant du verre, un objet de blocage noir (8) est agencé dans une position correspondant à un espace entre chaque paire de chaînes de cellules solaires et une position correspondant à un espace entre chaque paire de cellules solaires (4) sur une surface de la feuille arrière (7) à proximité du réseau de chaînes de cellules solaires, et l'objet de blocage noir (8) comprend au moins un parmi un placage de glaçure noire, un film adhésif noir ou un ruban noir (14).

11. Module photovoltaïque selon l'une quelconque des revendications 1 à 7, dans lequel le module photovoltaïque comprend en outre : une pluralité de cadres noirs situés autour du stratifié, dans lequel un premier motif d'onde est agencé sur une surface A du cadre noir ; et/ou
un chanfrein en forme d'arc est agencé à chaque coin du module photovoltaïque ; et/ou le module photovoltaïque comprend en outre une boîte de jonction (5) située sur un côté de la feuille arrière (7) à l'opposé du réseau de chaînes de cellules solaires et un collier de serrage noir (6) configuré pour serrer la boîte de jonction (5) et d'autres lignes entourant la boîte de jonction (5).

12. Module photovoltaïque selon la revendication 10, dans lequel la feuille arrière (7) est constituée du matériau comprenant du verre, un trou traversant (71) est prévu sur la feuille arrière (7), l'objet de blocage noir (8) est agencé sur la surface de la feuille arrière (7) et autour du trou traversant (71), une distance entre l'objet de blocage noir (8) agencé autour du trou traversant (71) et le trou traversant (71) est dans la plage allant de 0 mm à 2,3 mm, et une forme d'une partie de l'objet de blocage de bloc à proximité du trou traversant (71) est cohérente avec une forme du trou traversant (71).

13. Système photovoltaïque, comprenant une pluralité de modules photovoltaïques selon l'une quelconque des revendications 1 à 12, agencés en un réseau.
